# EUROPEAN PATENT SPECIFICATION

(11) **EP 2 957 613 B1**
(45) Date of publication and mention of the grant of the patent: **18.11.2020**
(21) Application number: 14751996.1
(22) Date of filing: 10.02.2014
(51) Int. Cl.: C09K 3/14, B24B 37/04, C09G 1/02, H01L 21/02, B24B 37/00

(54) **POLISHING COMPOSITION, METHOD FOR PRODUCING POLISHING COMPOSITION AND METHOD FOR PRODUCING POLISHED ARTICLE**
POLIERZUSAMMENSETZUNG, HERSTELLUNGSVERFAHREN FÜR POLIERZUSAMMENSETZUNG UND HERSTELLUNGSVERFAHREN FÜR POLIERTEN ARTIKEL
COMPOSITION DE POLISSAGE, PROCÉDÉ DE PRODUCTION POUR COMPOSITION DE POLISSAGE ET PROCÉDÉ DE PRODUCTION POUR ARTICLE POLI

(30) Priority: 13.02.2013 JP 2013026020
(43) Date of publication of application: 23.12.2015
(73) Proprietor: Fujimi Incorporated, Kiyosu-shi, Aichi 452-8502 (JP)
(72) Inventor: TSUCHIYA, Kohsuke, Kiyosu-shi Aichi 452-8502 (JP); TANSHO, Hisanori, Kiyosu-shi Aichi 452-8502 (JP); ASADA, Maki, Kiyosu-shi Aichi 452-8502 (JP); SUGA, Yusuke, Kiyosu-shi Aichi 452-8502 (JP)
(74) Representative: Grünecker Patent- und Rechtsanwälte PartG mbB
(86) International application number: PCT/JP2014/053065
(87) International publication number: WO 2014/126051

(56) References cited:
- EP-A2- 1 813 656
- WO-A1-2009/154164
- WO-A1-2014/030570
- JP-A- 2005 268 664
- JP-A- 2006 086 462
- JP-A- 2007 073 548
- JP-A- 2007 095 946
- JP-A- 2008 053 415
- JP-A- 2010 034 509
- JP-A- 2011 119 405
- JP-A- 2012 038 960
- US-A1- 2006 113 283
- US-A1- 2011 183 581

## Description

### [Technical Field]

The present invention relates to a polishing composition used for polishing a polishing object. In particular, it relates to a polishing composition used primarily for polishing semiconductor substrates such as silicon wafers as well as other substrates.

The present application claims priority to Japanese Patent Application No. 2013-026020 filed on February 13, 2013.

### [Background Art]

The surface of a silicon wafer used as a component of a semiconductor device, is generally polished to a high quality mirror finished via a lapping step (rough polishing step) and a polishing step (precision polishing step). The polishing step typically comprises a first polishing step and a final polishing step. Patent Documents 1 to 3 are cited as technical literatures related to polishing compositions used primarily for polishing semiconductor substrates such as silicon wafers.

### [Citation List]

### [Patent Literature]

[Patent Document 1] Japanese Patent Application Publication No. 2005-085858
[Patent Document 2] Japanese Patent Application Publication No. 2004-128070
[Patent Document 3] Japanese Patent Application Publication No. 2010-034509

### [Summary of Invention]

### [Technical Problem]

Lately, higher quality surfaces have been demanded in semiconductor substrates such as silicon wafers. The precision of substrate surface inspection has also been improved. For instance, surface analyzers have been developed to detect fine defects such as scratches and bumps, that are several deca-nanometers deep or high. If fine defects such as those detectable by these systems can be reduced, surfaces of higher quality can be obtained.

Patent Document 1 discloses a technique that uses a polishing compound comprising hydroxyethyl cellulose and/or polyvinyl alcohol as well as a block polyether to improve the haze of a silicon wafer. Patent Document 2 discloses a technique that uses a polishing composition comprising colloidal or fumed silica having an average primary particle diameter of 5 nm to 30 nm and a water-soluble polymer to reduce the surface haze of a semiconductor wafer. However, haze reduction alone cannot effectively reduce fine defects (micro defects) as described above. Patent Document 3 teaches a technique that uses a water-soluble polymer having low viscosity as a semiconductor-wetting agent to enable easy removal by filtration of contaminants capable of causing micro defects and thereby to reduce the occurrence of micro defects. However, such a technique has been often insufficient in terms of the required level of latest micro defect reduction.

US 2006/113283 (A1) discloses a polishing composition containing at least one or more aminocarboxylic acids selected from the group consisting of serine, cysteine and dihydroxyethylglycine, ceria particles and an aqueous medium; a polishing process of a semiconductor substrate, including the step of polishing a semiconductor substrate with a polishing composition for a semiconductor substrate, containing at least one or more aminocarboxylic acids selected from the group consisting of serine, cysteine and dihydroxyethylglycine, ceria particles and an aqueous medium; a method for manufacturing a semiconductor device including the step of polishing a semiconductor substrate having a film formed on its surface, the film containing a silicon atom and having a shape with dents and projections, with a polishing pad pressed against a semiconductor substrate at a polishing load of from 5 to 100 kPa in the presence of a polishing composition for a semiconductor substrate, containing at least one or more aminocarboxylic acids selected from the group consisting of serine, cysteine and dihydroxyethylglycine, ceria particles and an aqueous medium.

EP 1 813 656 (A2) discloses a metal polishing liquid comprising an oxidizing agent and colloidal silica in which a part of a surface of the colloidal silica is covered with aluminum atoms, and a Chemical Mechanical Polishing method using the same. An amino acid, a compound having an isothiazoline-3-one skeleton, an organic acid, a passivated film forming agent, a cationic surfactant, a nonionic surfactant, and a water-soluble polymer may be contained. A metal polishing liquid which is used in Chemical Mechanical Polishing in manufacturing of a semiconductor device, attains low dishing of a subject to be polished, and can perform polishing excellent in in-plane uniformity of a surface to be polished.

US 2011/183581 (A1) discloses a polishing composition, containing abrasive grains and an acid represented either by R2-R1-SO3H (wherein R1 is a linear alkylene or hydroxyalkylene group having 1 to 4 carbon atoms, and R2 is a hydroxy group, a carboxy group, or a sulfonic acid group when R1 is the linear alkylene group, or R2 is a carboxy group or a hydroxymethyl group when R1 is the linear hydroxyalkylene group), or by C6H5-R3 (wherein R3 is a sulfonic acid group or a phosphonic acid group). The acid contained in the polishing composition is preferably isethionic acid or benzenesulfonic acid. The polishing composition is mainly used in the application of polishing silicon oxide materials including glass substrates for hard disks, synthetic quartz substrates for photomasks, and low-dielectric-constant films such as silicon dioxide films, BPSG films, PSG films, FSG films, and organosiloxane films of semiconductor devices.

An objective of the present invention is thus to provide a polishing composition that allows reducing the number of detectable micro defects as described above in a surface after polishing therewith. Another objective of this invention is to provide a method for producing such a polishing composition. Another related objective is to provide a method for producing a polished article (e.g. substrate) comprising a surface having few micro defects.

### [Solution to Problem]

When a polishing object (work piece) is polished with a polishing composition comprising an abrasive and a water-soluble polymer in water, depending on the type of water-soluble polymer, the water-soluble polymer may adhere to the abrasive in the polishing composition, causing the abrasive to exist in the polishing composition as aggregates dimensionally larger than the abrasive itself (abrasive grains alone). Such aggregates may behave as grains in the polishing composition and their behavior may affect the mechanical working during the polishing. With respect to a polishing composition comprising an abrasive and a water-soluble polymer in water, as a physical value different from the dimensions of the abrasive itself, the present inventors have focused attention on the grain size in consideration of the presence of the aggregates. In other words, when the water-soluble polymer adheres to the abrasive (abrasive grains), entities that exhibit particle-like behavior in the polishing composition have been perceived as grains and their size has been considered as the size of the grains in the polishing composition. Using dynamic light scattering as the means capable of accurately determining the grain size, earnest studies have been conducted on the relationship between the grain size and micro defects in polished surfaces. As a result, grain sizes capable of effectively reducing the micro defects have been discovered, whereby the present invention has been completed.

The polishing composition provided by this invention comprises an abrasive, a water-soluble polymer, and water. The polishing composition has a volume average particle diameter D_{A} of grains (which can be the abrasive alone, abrasive with surrounding water-soluble polymer adhered thereto, abrasive/water-soluble polymer assemblies) in the polishing composition of 20 nm to 60 nm when measured by dynamic light scattering at a concentration equivalent to 0.2 % (by mass) abrasive content. In addition, the abrasive contains a silica grain and has an average secondary particle diameter D_{P2} of 20 nm to 60 nm, and the polishing composition has a pH of 9.0 to 11.0. According to such a polishing composition, because the volume average particle diameter D_{A} of the grains is limited to the prescribed range, the occurrence of micro defects (in particular, surface defects caused by polishing processes, generally called PID (polishing induced defects) can be effectively reduced.

A preferable abrasive has an average primary particle diameter D_{P1} in a range of about 15 nm to 30 nm. A polishing composition comprising such an abrasive can achieve both reduction of micro defects and reduction of haze at a higher level.

A preferable abrasive has an average secondary particle diameter D_{P2} in a range of about 20 nm to 50 nm. A polishing composition comprising such an abrasive can achieve both reduction of micro defects and reduction of haze at a higher level.

A preferable water-soluble polymer has a weight average molecular weight (Mw) of 80 × 10⁴ or less (e.g. 1 × 10³ to 80 × 10⁴, typically 1 × 10⁴ to 80 × 10⁴). A water-soluble polymer having such a Mw is preferable because it is suitable for forming grains having a preferable volume average particle diameter D_{A} disclosed herein.

The polishing composition disclosed herein can be preferably made in an embodiment further comprising a basic compound, in addition to the abrasive, water-soluble polymer and water. According to the polishing composition in such an embodiment, the polishing efficiency can be increased by the effect of the basic compound.

This invention also provides a method for producing a polishing composition comprising an abrasive, a water-soluble polymer, a basic compound and water. The method comprises obtaining (which may be preparing, purchasing, receiving) a dispersion comprising the abrasive, basic composition and water. It also comprises obtaining an aqueous solution comprising the water-soluble polymer and water. It also comprises adding and mixing the aqueous solution to the dispersion. Such a production method is a method for producing the polishing composition comprising grains (which can be the abrasive alone, abrasive with surrounding water-soluble polymer adhered thereto, abrasive/water-soluble polymer assemblies) with a volume average particle diameter D_{A} of 20 nm to 60 nm when measured by dynamic light scattering at a concentration equivalent to 0.2 % (by mass) abrasive content. The abrasive contains a silica grain and has an average secondary particle diameter D_{P2} of 20 nm to 60 nm, and the polishing composition has a pH of 9.0 to 11.0.

This invention also provides a method for producing a polished article comprising supplying a polishing liquid (the term "liquid" herein encompasses a slurry) to a polishing object and polishing a surface of the polishing object with the polishing liquid. In the method, as the polishing liquid supplied to the polishing object, a polishing liquid comprising an abrasive, a water-soluble polymer and water is used. The polishing liquid comprises, as grains, the abrasive and aggregates formed by adhesion of the abrasive to the water-soluble polymer. In the polishing liquid, the grains have a volume average particle diameter D_{A} of 20 nm to 60 nm when measured by dynamic light scattering. The abrasive contains a silica grain and has an average secondary particle diameter D_{P2} of 20 nm to 60 nm, and the polishing composition has a pH of 9.0 to 11.0. According to such a production method, because the volume average particle diameter D_{A} of the grains in the polishing liquid is limited to the prescribed range, the occurrence of micro defects can be effectively reduced. Accordingly, a polished article can be provided, having a surface with fewer micro defects.

The art disclosed herein can be preferably applied to polishing a silicon wafer, for instance, a lapped silicon wafer. An example of particularly preferable applications is final polishing of a silicon wafer.

### [Description of Embodiments]

Preferred embodiments of the present invention are described below. Matters necessary to implement this invention other than those specifically referred to in this specification may be understood as design matters to a person of ordinary skill in the art based on the conventional art in the pertinent field. The present invention can be implemented based on the contents disclosed in this specification and common technical knowledge in the subject field. In this specification, the terms "weight" and "mass," "% by weight" and "% by mass," and "parts by weight" and "parts by mass" are used synonymously.

### < Abrasive >

The material and properties of the abrasive in the polishing composition disclosed herein are not particularly limited and can be suitably selected in accordance with the purpose and application of the polishing composition. Examples of the abrasive include inorganic grains, organic grains and organic/inorganic composite grains, provided that the abrasive contains a silica grain. Specific examples of inorganic grains include oxide grains such as alumina grains, cerium oxide grains, chromium oxide grains, titanium dioxide grains, zirconium oxide grains, magnesium oxide grains, manganese dioxide grains, zinc oxide grains, and red oxide grains; nitride grains such as silicon nitride grains, and boron nitride grains; carbide grains such as silicon carbide grains, and boron carbide grains; diamond grains; carbonates such as calcium carbonate, and barium carbonate. Specific examples of organic grains include polymethyl methacrylate (PMMA) grains, poly(meth)acrylic acid grains (herein the (meth)acrylic acid comprehensively means acrylic acid and methacrylic acid), and polyacrylonitrile grains. These abrasives can be used singly as one species or in a combination of two or more species.

The abrasive contains a silica grain. Specific examples of silica grains include colloidal silica, fumed silica, and precipitated silica. From the standpoint of the less likelihood of scratching the polishing object surface and capability of making a surface with lower haze, colloidal silica and fumed silica are cited as preferable silica grains. Colloidal silica is particularly preferable. For instance, colloidal silica is preferably used as the abrasive in the polishing composition used for polishing (especially, final polishing) of a silicon wafer.

The silica constituting the silica grains has a true specific gravity of preferably 1.5 or higher, more preferably 1.6 or higher, or yet more preferably 1.7 or higher. With increasing true specific gravity of the silica, the polishing rate (amount of surface removed from article surface per unit time) may increase when polishing a polishing object (e.g. silicon wafer). From the standpoint of reducing scratches occurring in the surface (polished surface) of the polishing object, preferable silica grains have a true specific gravity of 2.2 or lower. As the true specific gravity of the silica, the value measured by a liquid displacement method using ethanol as the displacing liquid can be used.

In the art disclosed herein, the abrasive in the polishing composition can be in a form of primary particles or in a form of secondary particles which are aggregates of primary particles. Alternatively, the abrasive may be present both in the primary particle form and secondary particle form. In a preferable embodiment, the abrasive is present at least partially in a secondary particle form in the polishing composition.

In the art disclosed herein, the abrasive's average primary particle diameter D_{P1} is not particularly limited as far as it allows the grains in the polishing composition to satisfy certain conditions of size distribution. In a preferable embodiment, the abrasive has an average primary particle diameter D_{P1} of 5 nm or larger or more preferably 10 nm or larger. With increasing average primary particle diameter of the abrasive, a higher polishing rate can be obtained. From the standpoint of obtaining greater effects of polishing (e.g. effects such as reduced haze, removal of defects), the average primary particle diameter D_{P1} is preferably 15 nm or larger, or more preferably 20 nm or larger (e.g. larger than 20 nm). From the standpoint of the likelihood of being present as grains dimensionally suitable for reduction of micro defects in the polishing composition, the average primary particle diameter D_{P1} is preferably smaller than 35 nm, more preferably 32 nm or smaller, or yet more preferably 30 nm or smaller (e.g. smaller than 30 nm).

In the art disclosed herein, the average primary particle diameter D_{P1} of the abrasive can be determined, for instance, from the specific surface area S (m²/g) measured by the BET method by an equation D_{P1} = 2720/S (nm). The specific surface area of the abrasive can be measured using, for instance, a specific surface area analyzer under trade name "FLOW SORB II 2300" available from Micromeritics.

The abrasive's average secondary particle diameter D_{P2} (which refers to the volume average secondary particle diameter of the abrasive alone) is as defined in the claims. With increasing average secondary particle diameter D_{P2} of the abrasive, a higher polishing rate can be obtained. From the standpoint of obtaining greater effects of polishing, the average secondary particle diameter D_{P2} is preferably 30 nm or larger, more preferably 35 nm or larger, or yet more preferably 40 nm or larger (e.g. larger than 40 nm). From the standpoint of the likelihood of being present in the polishing composition as grains dimensionally suitable for reduction of micro defects, the average secondary particle diameter D_{P2} is preferably 55 nm or smaller, or more preferably 50 nm or smaller (e.g. smaller than 50 nm).

The abrasive's average secondary particle diameter D_{P2} can be measured for an aqueous dispersion of the abrasive of interest (but free of a water-soluble polymer) as a measurement sample by dynamic light scattering using, for instance, model "UPA-UT151" available from Nikkiso Co., Ltd.

The abrasive's average secondary particle diameter D_{P2} is generally equal to or larger than the abrasive's average primary particle diameter D_{P1} (D_{P2/}D_{P1} ≥ 1) and is typically larger than D_{P1} (D_{P2/}D_{P1} > 1). Although not particularly limited, from the standpoint of the effects of polishing and post-polishing surface smoothness, D_{P2}/D_{P1} of the abrasive is usually suitably in a range of 1.2 to 3, preferably in a range of 1.5 to 2.5, or more preferably in a range of 1.7 to 2.3 (e.g. greater than 1.9, but 2.2 or less).

The abrasive grain's shape (external shape) may be a globular shape or a non-globular shape. Specific examples of non-globular shapes of the abrasive include a peanut shape (i.e. peanut shell shape), cocoon shape, confeito shape (spiky ball shape), and rugby ball shape. For instance, the abrasive mostly comprising peanut-shaped grains can be preferably used.

Although not particularly limited, the abrasive has an average value of primary particle's major axis to minor axis ratio (average aspect ratio) of preferably 1.0 or higher, more preferably 1.05 or higher, or yet more preferably 1.1 or higher. With increasing average aspect ratio of the abrasive, a higher polishing rate can be obtained. From the standpoint of scratch reduction and so on, the abrasive's average aspect ratio is preferably 3.0 or lower, more preferably 2.0 or lower, or yet more preferably 1.5 or lower.

The abrasive's shape (external shape) and average aspect ratio can be assessed, for instance by electron microscope observations. In specific procedures, for instance, using a scanning electron microscope (SEM), with respect to a prescribed number (e.g. 200) of abrasive grains having observable separate shapes, the smallest circumscribing rectangles are drawn on the respective grain images. With respect to the rectangle drawn on each grain image, the long side length (major axis length) is divided by the short side length (minor axis length) to determine the major axis/minor axis ratio (aspect ratio). The aspect ratios of the prescribed number of grains can be arithmetically averaged to determine the average aspect ratio.

### < Water-soluble polymer >

The type of water-soluble polymer in the polishing composition disclosed herein is not particularly limited. For instance, among water-soluble polymers known in the field of polishing compositions, one can be selected so as to form grains in desirable sizes in a polishing composition having an abrasive content of 0.2 % by mass. Water-soluble polymers can be used singly as one species or in a combination of two or more species.

The water-soluble polymer may have at least one species of functional group in the molecule, selected from cation groups, anion groups and nonion groups. In the molecule, the water-soluble polymer may have, for instance, a hydroxyl group, carboxyl group, acyloxy group, sulfo group, quaternary nitrogen structure, heterocyclic structure, vinyl structure, or polyoxyalkylene structure.

Examples of water-soluble polymers that can be preferably used in the polishing composition disclosed herein include a cellulose derivative; an oxyalkylene unit-containing polymer; a polymer comprising an N-vinyl monomeric unit such as N-vinyllactam, open-chain N-vinylamide; an imine derivative; a polymer comprising a N-(meth)acryloyl monomeric unit; a vinyl alcohol-based polymer such as polyvinyl alcohol and a derivative thereof; and pullulan.

Specific examples of the cellulose derivative (or "water-soluble polymer PA" hereinafter) include hydroxyethyl cellulose, hydroxypropyl cellulose, hydroxyethylmethyl cellulose, hydroxypropylmethyl cellulose, methyl cellulose, ethyl cellulose, ethylhydroxyethyl cellulose, and carboxymethyl cellulose. In particular, hydroxyethyl cellulose is preferable.

The oxyalkylene unit-containing polymer (or "water-soluble polymer PB" hereinafter) may comprise one, two or more species of oxyalkylene unit with 2 to 6 carbon atoms (typically, a structural unit represented by -CₙH₂ₙO- wherein n is an integer between 2 and 6). The number of carbon atoms in the oxyalkylene unit is preferably 2 to 3. Examples of such a polymer include a polyethylene oxide, a block copolymer of ethylene oxide (EO) and propylene oxide (PO), and a random copolymer of EO and PO.

The block copolymer of EO and PO can be a diblock copolymer, triblock copolymer or the like comprising a polyethylene oxide block (PEO) and a polypropylene oxide block (PPO). Examples of the triblock copolymer include a PEO-PPO-PEO triblock copolymer and PPO-PEO-PPO triblock copolymer. Usually, a PEO-PPO-PEO triblock copolymer is more preferable.

As the PEO-PPO-PEO triblock copolymer, a polymer represented by the following formula (1) can be preferably used:

HO-(EO)ₐ-(PO)_{b}(EO)_{c}-H (1)

In the general formula (1), EO represents an oxyethylene unit (-CH₂CH₂O-), PO represents an oxypropylene unit (-CH₂CH(CH₃)O-), and each of a, b and c is an integer of 1 or higher (typically 2 or higher).

In the general formula (1), the total of a and c is preferably in a range of 2 to 1000, more preferably in a range of 5 to 500, or yet more preferably in a range of 10 to 200. In the general formula (1), b is preferably in a range of 2 to 200, more preferably in a range of 5 to 100, or yet more preferably in a range of 10 to 50.

In the block copolymer or random copolymer of EO and PO, from the standpoint of the water solubility and washability, the molar ratio (EO/PO) between EO and PO constituting the copolymer is preferably higher than 1, more preferably 2 or higher, or yet more preferably 3 or higher (e.g. 5 or higher).

Examples of the N-vinyl monomeric unit-containing polymer (or "water-soluble polymer PC" hereinafter) include a homopolymer of an N-vinyllactam-based monomer and a copolymer thereof (e.g. a copolymer in which the copolymerization ratio of the N-vinyllactam-based monomer exceeds 50 % by weight), and a homopolymer of an open-chain N-vinylamide and a copolymer thereof (e.g. a copolymer in which the copolymerization ratio of the open-chain N-vinylamide exceeds 50 % by weight).

Unless otherwise indicated, the copolymer in this specification comprehensively means various copolymers such as random copolymer, alternating copolymer, block copolymer, and graft copolymer.

Specific examples of the N-vinyllactam-based monomer include N-vinylpyrrolidone (VP), N-vinylpiperidone, N-vinylmorpholinone, N-vinylcaprolactam (VC), N-vinyl-1,3-oxazine-2-one, and N-vinyl-3,5-morpholinedione. Specific examples of the N-vinyllactam monomeric unit-containing polymer include a polyvinylpyrrolidone, polyvinylcaprolactam, random copolymer of VP and VC, random copolymer of one or each of VP and VC with another vinyl monomer (e.g. acrylic monomer, vinyl ester-based monomer), and block copolymer and graft copolymer comprising a polymer segment with one or each of VP and VC (e.g. a graft copolymer obtained by grafting polyvinyl alcohol with polyvinylpyrrolidone). A particularly preferable species is a vinylpyrrolidone-based polymer (PVP). Herein the vinylpyrrolidone-based polymer refers to a VP homopolymer and a VP copolymer (e.g. a copolymer in which the copolymerization ratio of VP exceeds 50 % by weight). In the vinylpyrrolidone-based polymer, the molar ratio of VP units to all the repeating units is usually 50 % or higher and suitably 80 % or higher (e.g. 90 % or higher, typically 95 % or higher). Essentially all the repeating units in the water-soluble polymer may be formed with VP units.

Specific examples of the open-chain N-vinylamide include N-vinylacetamide, N-vinylpropionic acid amide, and N-vinyllactic acid amide.

The imine derivative (or "water-soluble polymer PD" hereinafter) includes a homopolymer and a copolymer of an N-acylalkyleneimine-based monomer. Specific examples of the N-acylalkyleneimine-based monomer include N-acetylethyleneimine, N-propionylethyleneimine, N-caproylethyleneimine, N-benzoylethyleneimine, N-acetylpropyleneimine, and N-butyrylethyleneimine. As the homopolymer of N-acylalkyleneimine-based monomer, a poly(N-acylalkyleneimine) and the like can be used. Specific examples include poly(N-acetylethyleneimine), poly(N-propionylethyleneimine), poly(N-caproylethyleneimine), poly(N-benzoylethyleneimine), poly(N-acetylpropyleneimine), and poly(N-butyrylethyleneimine). Examples of the copolymer of N-acylalkyleneimine-based monomer include a copolymer of two or more species of N-acylalkyleneimine-based monomer and a copolymer of one, two or more species of N-acylalkyleneimine-based monomer and other monomer(s).

Examples of the N-(meth)acryloyl monomeric unit-containing polymer (or "water-soluble polymer PE" hereinafter) include a homopolymer of an N-(meth)acryloyl-based monomer and a copolymer thereof (typically a copolymer in which the copolymerization ratio of N-(meth)acryloyl-based monomer exceeds 50 % by weight). Examples of the N-(meth)acryloyl-based monomer include an open-chain amide having an N-(meth)acryloyl group and a cyclic amide having an N-(meth)acryloyl group.

Examples of an open-chain amide having an N-(meth)acryloyl group include: acrylamide; N-monoalkylacrylamides such as N-methylacrylamide, N-ethylacrylamide, N-propylacrylamide, N-isopropylacrylamide, N-butylacrylamide, N-isobutylacrylamide, N-tert-butylacrylamide, N-heptylacrylamide, N-octylacrylamide, N-tert-octylacrylamide, N-dodecylacrylamide, and N-octadecylacrylamide; substituted N-monoalkylacrylamides such as N-(2-hydroxyethyl)acrylamide, N-(1,1-dimethyl-2-hydroxyethyl)acrylamide, N-(1-ethyl-hydroxyethyl)acrylamide, N-(2-chloroethyl)acrylamide, N-(2,2,2-trichloro-1-hydroxyethyl)acrylamide, N-(2-dimethylaminoethyl)acrylamide, N-(3-dimethylaminopropyl)acrylamide, N-[3-bis(2-hydroxyethyl)aminopropyl]acrylamide, N-(1,1-dimethyl-2-dimethylaminoethyl)acrylamide, N-(2-methyl-2-phenyl-3-dimethylaminopropyl)acrylamide, N-(2,2-dimethyl-3-dimethylaminopropyl)acrylamide, N-(2-morpholinoethyl)acrylamide, and N-(2-amino-1,2-dicyanoethyl)acrylamide; N-monoalkenylacrylamides such as N-allylacrylamide; N-monoalkynylacrylamides such as N-(1,1-dimethylpropynyl)acrylamide; aromatic group-containing acrylamides such as N-phenylacrylamide, N-benzylacrylamide, and N-[4-(phenylamino)phenyl]acrylamide; N-monoalkylolacrylamides such as N-methylolacrylamide, N-ethylolacrylamide, N-propylolacrylamide, etc.; N-alkoxyalkylacrylamides such as N-methoxymethylacrylamide, N-ethoxymethylacrylamide, N-butoxymethylacrylamide, and N-isobutoxymethylacrylamide; N-alkoxyacrylamides such as N-methoxyacrylamide, N-ethoxyacrylamide, N-propoxyacrylamide, and N-butoxyacrylamide; N-acetylacrylamide; N-diacetoneacrylamide; methacrylamide; N-monoalkylmethacrylamides such as N-methylmethacrylamide, N-ethylmethacrylamide, N-propylmethacrylamide, N-isopropylmethacrylamide, N-butylmethacrylamide, N-isobutylmethacrylamide, N-tert-butylmethacrylamide, N-heptylmethacrylamide, N-octylmethacrylamide, N-tert-octylmethacrylamide, and N-dodecylmethacrylamide, N-octadecylmethacrylamide; substituted N-monoalkylmethacrylamides such as N-(2-hydroxyethyl)methacrylamide, N-(1,1-dimethyt-2-hydroxyethyt)methacrytamide, N-(1-ethylhydroxyethyl)methacrylamide, N-(2-chloroethyl)methacrylamide, N-(2,2,2-trichloro-1-hydroxyethyl)methacrylamide, N-(2-dimethylaminoethyl)methacrylamide, N-(3-dimethylaminopropyl)methacrylamide, N-[3-bis(2-hydroxyethyl)aminopropyl]methacrylamide, N-(1,1-dimethyl-2-dimethylaminoethyl)methacrylamide, N-(2-methyl-2-phenyl-3-dimethylaminopropyl)methacrylamide, N-(2,2-dimethyl-3-dimethylaminopropyl)methacrylamide, N-(2-morpholinoethyl)methacrylamide, and N-(2-amino-1,2-dicyanoethyl)methacrylamide; N-monoalkenylmethacrylamides such as N-allylmethacrylamide; N-monoalkynylmethacrylamides such as N-(1,1-dimethylpropynyl)methacrylamide; aromatic group-containing methacrylamides such as N-phenylmethacrylamide, N-benzylmethacrylamide, and N-[4-(phenylamino)phenyl]methacrylamide; N-monoalkylolmethacrylamides such as N-methylolmethacrylamide, N-ethylolmethacrylamide, and N-propylolmethacrylamide; N-alkoxyalkylmethacrylamides such as N-methoxymethylmethacrylamide, N-ethoxymethylmethacrylamide, N-butoxymethylmethacrylamide, N-isobutoxymethylmethacrylamide, etc.; N-alkoxymethacrylamides such as N-methoxymethacrylamide, N-ethoxymethacrylamide, N-propoxymethacrylamide, and N-butoxymethacrylamide; N-acetylmethacrylamide; N-diacetonemethacrylamide; N,N-dialkylacrylamides such as N,N-dimethylacrylamide, N,N-diethylacrylamide, N,N-dipropytacrylamide, N,N-diisopropylacrylamide, N,N-dibutylacrylamide, N,N-diisobutylacrylamide, N,N-di-tert-butylacrylamide, N,N-diheptylacrylamide, N,N-dioctylacrylamide, N,N-di-tert-octylacrylamide, N,N-didodecylacrylamide, and N,N-dioctadecylacrylamide; N,N-dialkylaminoalkylacrylamides such as N,N-dimethylaminoethylacrylamide, N,N-diethylaminoethylacrylamide, N,N-dimethylaminopropylacrylamide, and N,N-diethylaminopropylacrylamide; substituted N,N-dialkylacrylamides such as N,N-bis(2-hydroxyethyl)acrylamide, and N,N-bis(2-cyanoethyl)acrylamide; N,N-dialkenylacrylamides such as N,N-diallylacrylamide; aromatic group-containing acrylamides such as N,N-diphenylacrylamide, and N,N-dibenzylacrylamide; N,N-dialkylolacrylamides such as N,N-dimethylolacrylamide, N,N-diethylolacrylamide, and N,N-dipropylolacrylamide; N-alkoxy-N-alkylacrylamides such as N-methyl-N-methoxyacrylamide, N-methyl-N-ethoxyacrylamide, N-methyl-N-propoxyacrylamide, N-methyl-N-butoxyacrylamide, N-ethyl-N-methoxyacrylamide, N-ethyl-N-ethoxyacrylamide, N-ethyl-N-butoxyacrylamide, N-propyl-N-methoxyacrylamide, N-propyl-N-ethoxyacrylamide, N-butyl-N-methoxyacrylamide, and N-butyl-N-ethoxyacrylamide; N,N-diacetylacrylamide; N,N-diacetoneacrylamide; N,N-dialkylmethacrylamides such as N,N-dimethylmethacrylamide, N,N-diethylmethacrylamide, N,N-dipropylmethacrylamide, N,N-diisopropylmethacrylamide, N,N-dibutylmethacrylamide, N,N-diisobutylmethacrylamide, N,N-di-tert-butylmethacrylamide, N,N-diheptylmethacrylamide, N,N-dioctylmethacrylamide, N,N-di-tert-octylmethacrylamide, N,N-didodecylmethacrylamide, and N,N-dioctadecylmethacrylamide; N,N-dialkylaminoalkylmethacrylamides such as N,N-dimethylaminoethylmethacrylamide, N,N-diethylaminoethylmethacrylamide, N,N-dimethylaminopropylmethacrylamide, and N,N-diethylaminopropylmethacrylamide; substituted N,N-dialkylmethacrylamides such as N,N-bis(2-hydroxyethyl)methacrylamide, and N,N-bis(2-cyanoethyl)methacrylamide; N-dialkenylmethacrylamides such as N,N-diallylmethacrylamide; aromatic group-contaning methacrylamides such as N,N-diphenylmethacrylamide, and N,N-dibenzylmethacrylamide; N,N-dialkylolmethacrylamides such as N,N-dimethylolmethacrylamide, N,N-diethylolmethacrylamide, and N,N-dipropylolmethacrylamide; N-alkoxy-N-alkylmethacrylamides such as N-methyl-N-methoxymethacrylamide, N-methyl-N-ethoxymethacrylamide, N-methyl-N-propoxymethacrylamide, N-methyl-N-butoxymethacrylamide, N-ethyl-N-methoxymethacrylamide, N-ethyl-N-ethoxymethacrylamide, N-ethyl-N-butoxymethacrylamide, N-propyl-N-methoxymethacrylamide, N-propyl-N-ethoxymethacrylamide, N-butyl-N-methoxymethacrylamide, and N-butyl-N-ethoxymethacrylamide; N,N-diacetylmethacrylamide; and N,N-diacetonemethacrylamide.

Examples of a polymer comprising a N-(meth)acryloyl group-containing open-chain amide as a monomeric unit include a homopolymer of N-isopropylacrylamide and a copolymer of N-isopropylacrylamide (e.g. a copolymer in which the copolymerization ratio of N-isopropylacrylamide exceeds 50 % by weight).

Examples of the N-(meth)acryloyl group-containing cyclic amide include N-acryloylmorpholine, N-acryloylthiomorpholine, N-acryloylpiperidine, N-acryloylpyrrolidine, N-methacryloylmorpholine, N-methacryloylpiperidine, and N-methacryloylpyrrolidine. An example comprising an N-(meth)acryloyl group-containing cyclic amide as a monomeric unit is an acryloylmorpholine-based polymer (PACMO). Typical examples of the acryloylmorpholine-based polymer include a homopolymer of N-acryloylmorpholine (ACMO) and a copolymer of ACMO (e.g. a copolymer in which the copolymerization ratio of ACMO exceeds 50 % by weight). In the acryloylmorpholine-based polymer, the molar ratio of ACMO units to all the repeating units is usually 50 % or higher and suitably 80 % or higher (e.g. 90 % or higher, typically 95 % or higher). Essentially all the repeating units in the water-soluble polymer may be formed with ACMO units.

The vinyl alcohol-based polymer (or "water-soluble polymer PF' hereinafter) (PVA) typically comprises a vinyl alcohol unit (VA unit) as the primary repeating unit. In this polymer, the molar ratio of VA units to all the repeating units is usually 50 % or higher, preferably 65 % or higher, or more preferably 70 % or higher, for instance, 75 % or higher. Essentially all the repeating units may be formed with VA units. In the water-soluble polymer PF, the type(s) of repeating unit(s) other than the VA unit are not particularly limited. Examples include vinyl acetate unit, vinyl propionate unit, vinyl hexanoate unit.

PVA has a degree of saponification of usually 50 % by mole or higher, preferably 65 % by mole or higher, or more preferably 70 % by mole or higher, for instance, 75 % by mole or higher. The degree of saponification of PVA is theoretically 100 % by mole or lower.

The polishing composition disclosed herein can be preferably made in an embodiment comprising, as the water-soluble polymer, for instance, at least a water-soluble polymer PA and/or a water-soluble polymer PF. A preferable embodiment comprises at least a water-soluble polymer PA (typically hydroxyethyl cellulose) as the water-soluble polymer. For example, an embodiment that comprises a water-soluble polymer PA solely, an embodiment comprising a water-soluble polymer PA and a water-soluble polymer PC, an embodiment comprising a water-soluble polymer PA and a water-soluble polymer PE, and like embodiment can be employed. In a preferable example of such a polishing composition, the primary component (typically the component accounting for more than 50 % by mass) of the water-soluble polymer is hydroxyethyl cellulose. Of the water-soluble polymer, hydroxyethyl cellulose may account for 60 % by mass or higher, for instance, 80 % by mass or higher, or more preferably 90 % by mass or higher. 100 % by mass of the water-soluble polymer may be hydroxyethyl cellulose. Another preferable embodiment comprises at least a water-soluble polymer PF as the water-soluble polymer. For example, an embodiment that comprises a water-soluble polymer PF solely, an embodiment comprising a water-soluble polymer PF and a water-soluble polymer PC, an embodiment comprising a water-soluble polymer PF and a water-soluble polymer PA, and like embodiment can be employed. Another preferable embodiment of the polishing composition disclosed herein comprises a water-soluble polymer PE solely as the water-soluble polymer.

In the polishing composition disclosed herein, the molecular weight of the water-soluble polymer is not particularly limited. For instance, a water-soluble polymer having a weight average molecular weight (Mw) of 200 × 10⁴ or smaller (typically 1 × 10¹ to 200 × 10⁴, e.g. 1 × 10³ to 150 × 10⁴) can be used. From the standpoint of the likelihood of forming grains in suitable sizes disclosed herein, the use of a water-soluble polymer having a Mw of smaller than 100 × 10⁴ (more preferably 80 × 10⁴ or smaller, yet more preferably 50 × 10⁴ or smaller, typically 40 × 10⁴ or smaller) is preferable. From the standpoint of the ease of filtering and washing the polishing composition, a water-soluble polymer having a Mw of 30 × 10⁴ or smaller (typically smaller than 30 × 10⁴) can be preferably used. On the other hand, in general, with increasing Mw of water-soluble polymer, the haze reduction effect tends to increase. From such a standpoint, it is usually suitable to use a water-soluble polymer having a Mw of 1 × 10¹ or larger. For instance, a water-soluble polymer having a Mw of 1 × 10⁴ or larger can be preferably used.

More preferable Mw ranges may also vary depending on the type of water-soluble polymer. For instance, the Mw of water-soluble polymer PA is typically smaller than 100 × 10⁴, preferably 80 × 10⁴ or smaller, more preferably 50 × 10⁴ or smaller, or yet more preferably 30 × 10⁴ or smaller (typically smaller than 30 × 10⁴). The Mw of water-soluble polymer PA is typically 1 × 10⁴ or larger, preferably 2 × 10⁴ or larger, more preferably 3 × 10⁴ or larger, or yet more preferably 5 × 10⁴ or larger (e.g. 7 × 10⁴ 0r larger). For instance, the Mw of water-soluble polymer PB is preferably 50 × 10⁴ or smaller, more preferably 30 × 10⁴ or smaller, or yet more preferably 20 × 10⁴ or smaller. The Mw of water-soluble polymer PB is typically 1 × 10⁴ or larger. For instance, the Mw of water-soluble polymer PC is typically 15 × 10⁴ or smaller, preferably 10 × 10⁴ or smaller, or more preferably 8 × 10⁴ or smaller. A water-soluble polymer PC having a Mw of 5 × 10⁴ or smaller (e.g. 3 × 10⁴ or smaller) can be used as well. The Mw of water-soluble polymer PC is typically 1 × 10⁴ or larger. For instance, the Mw of water-soluble polymer PD is preferably 30 × 10⁴ or smaller, more preferably 20 × 10⁴ or smaller, or yet more preferably 10× 10⁴ or smaller (e.g. 5 × 10⁴ or smaller). The Mw of water-soluble polymer PD is typically 1 × 10⁴ or larger. For instance, the Mw of water-soluble polymer PE is typically 40 × 10⁴ or smaller, preferably 20 × 10⁴ or smaller, or more preferably 10 × 10⁴ or smaller. The Mw of water-soluble polymer PE is typically 1 × 10⁴ or larger. For instance, the Mw of water-soluble polymer PF (PVA) is typically 6 × 10⁴ or smaller, preferably 5.5 × 10⁴ or smaller, or more preferably 3 × 10⁴ or smaller (e.g. 2 × 10⁴ or smaller). The Mw of water-soluble polymer PF is typically 1 × 10³ or larger, or preferably 3 × 10³ or larger, for example, 4 × 10¹ or larger. A water-soluble polymer PF having a Mw of 1 × 10⁴ or larger can be used as well.

In the art disclosed herein, the relationship between the weight average molecular weight (Mw) and number average molecular weight (Mn) of the water-soluble polymer is not particularly limited. For instance, a polymer having Mw and Mn satisfying the next equation Mw/Mn ≤ 5.0 can be preferably used. From the standpoint of the performance stability of the polishing composition, the Mw/Mn of the water-soluble polymer is preferably 4.8 or smaller, or more preferably 4.6 or smaller. Theoretically, the Mw/Mn is 1.0 or greater. As the Mw and Mn of the water-soluble polymer, the values based on GPC (aqueous, based on standard polyethylene oxide) can be used.

More preferable ranges of the Mw/Mn may also vary depending on the type of water-soluble polymer. For instance, the Mw/Mn of water-soluble polymer PA is preferably 4.8 or lower, or more preferably 4.6 or lower. For instance, the Mw/Mn of water-soluble polymer PB is preferably 4.0 or lower, more preferably 3.5 or lower, or yet more preferably 3.0 or lower. For instance, the Mw/Mn of water-soluble polymer PC is preferably 4.0 or lower, more preferably 3.5 or lower, or yet more preferably 3.0 or lower. For instance, the Mw/Mn of water-soluble polymer PD is preferably 4.0 or lower, more preferably 3.5 or lower, or yet more preferably 3.0 or lower. For instance, the Mw/Mn of water-soluble polymer PE is preferably 4.0 or lower, more preferably 3.5 or lower, or yet more preferably 3.0 or lower.

On the other hand, for instance, the Mw/Mn of water-soluble polymer PA is preferably 2.0 or higher, or more preferably 3.0 or higher. For instance, the Mw/Mn of water-soluble polymer PB is preferably 1.05 or higher. For instance, the Mw/Mn of water-soluble polymer PC is preferably 1.05 or higher. For instance, the Mw/Mn of water-soluble polymer PD is preferably 1.05 or higher. For instance, the Mw/Mn of water-soluble polymer PE is preferably 1.05 or higher.

The Mw/Mn of water-soluble polymer PF is preferably 4.0 or lower, more preferably 3.5 or lower, or yet more preferably 3.0 or lower. The Mw/Mn of water-soluble polymer PF is preferably 1.05 or higher.

As the Mw and Mn of a water-soluble polymer, the values based on aqueous gel permeation chromatography (GPC) (aqueous, based on standard polyethylene oxide) can be used.

Although not particularly limited, the water-soluble polymer content can be, for instance, 0.01 part by mass or higher to 100 parts by mass of the abrasive. From the standpoint of increasing the post-polishing surface smoothness (e.g. reduction of haze and defects), the water-soluble polymer content relative to 100 parts by mass of the abrasive is suitably 0.05 part by mass or higher, preferably 0.1 part by mass or higher, or more preferably 0.5 part by mass or higher (e.g. 1 part by mass or higher). From the standpoint of the polishing rate and washability, the water-soluble polymer content relative to 100 parts by mass of the abrasive can be, for instance, 40 parts by mass or less, usually suitably 20 parts by mass or less, preferably 15 parts by mass or less, or more preferably 10 parts by mass or less.

### < Water >

As the water in the polishing composition disclosed herein, ion-exchanged water (deionized water), pure water, ultrapure water, and distilled water can be preferably used. To avoid hindering the effects of other components in the polishing composition whenever possible, in the water used, for instance, the total transition metal ion content is preferably 100 ppb or less. For example, the purity of the water can be increased by operations such as removing impurity ions with ion-exchange resin, removing contaminants with a filter, distillation, and so on.

The polishing composition disclosed herein may further comprise, as necessary, a water-miscible organic solvent (lower alcohol, lower ketone). In usual, of the solvent in the polishing composition, preferably 90 % by volume or more is water, or more preferably 95 % by volume or more (typically 99 to 100 % by volume) is water.

The polishing composition disclosed herein (typically a slurry composition) can be preferably made, for instance, in an embodiment in which the non-volatile content (NV) is 0.01 % by mass to 50 % by mass and the rest is an aqueous solvent (water or a mixture of water and the organic solvent) or in an embodiment where the rest is an aqueous solvent and a volatile compound (e.g. ammonia). An embodiment wherein the NV is 0.05 % by mass to 40 % by mass is more preferable. The non-volatile content (NV) refers to the mass proportion of residue remaining in the polishing composition after drying the polishing composition at 105 °C for 24 hours.

### < Basic compound >

The polishing compound disclosed herein typically comprises a basic compound besides the abrasive, water-soluble polymer and water. Herein, the basic compound refers to a compound having an ability to increase the pH of a polishing composition upon addition to the composition. The basic compound may work to chemically polish the target surface and contribute to increase the polishing rate. The basic compound may also help increase the dispersion stability of the polishing composition.

As the basic compound, organic or inorganic nitrogen-containing basic compounds, hydroxides of alkali metals or alkaline earth metals, various carbonates and hydrogen carbonates, can be used. Examples include alkali metal hydroxides; quaternary ammonium hydroxides and salts thereof; ammonia; and amines. Specific examples of alkali metal hydroxides include potassium hydroxide, and sodium hydroxide. Specific examples of carbonates and hydrogen carbonates include ammonium hydrogen carbonate, ammonium carbonate, potassium hydrogen carbonate, potassium carbonate, sodium hydrogen carbonate, and sodium carbonate. Specific examples of quaternary ammonium hydroxides or salts thereof include such as tetramethylammonium hydroxide, tetraethylammonium hydroxide, and tetrabutylammonium hydroxide. Specific examples of amines include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetraamine, anhydrous piperazine, piperazine hexahydrate, 1-(2-aminoethyl)piperazine, N-methylpiperazine, guanidine, azoles such as imidazole, and triazole. These basic compounds can be used singly as one species or in a combination of two or more species.

Examples of basic compounds preferable from the standpoint of increasing the polishing rate, include ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate and sodium carbonate. In particular, preferable examples include ammonia, potassium hydroxide, sodium hydroxide, tetramethylammonium hydroxide and tetraethylammonium hydroxide. As more preferable species, ammonia and tetramethylammonium hydroxide are cited. An especially preferable basic compound is ammonia.

### < Surfactant >

The polishing composition disclosed herein can be preferably made in an embodiment comprising a surfactant (typically a water-soluble organic compound having a molecular weight below 1 × 10⁴) besides the abrasive, water-soluble polymer and water. The use of surfactant may increase the dispersion stability of the polishing composition. It may facilitate the reduction of haze. For the surfactant, solely one species or a combination of two or more species can be used.

As the surfactant, anionic or nonionic kinds can be preferably used. From the standpoint of the low-foaming properties and easy pH adjustment, nonionic surfactants are more preferable. Examples include oxyalkylene polymers such as polyethylene glycol, polypropylene glycol, and polytetramethylene glycol; polyoxyalkylene adducts such as polyoxyethylene alkyl ether, polyoxyethylene alkyl phenyl ether, polyoxyethylene alkylamine, polyoxyethylene fatty acid ester, polyoxyethylene glyceryl ether fatty acid ester, and polyoxyethylene sorbitan fatty acid ester; and copolymers (diblock copolymer, triblock copolymer, random copolymer, alternating copolymer) of several species of oxyalkylene.

Specific examples of nonionic surfactant include a block copolymer of EO and PO (diblock copolymer, PEO-PPO-PEO triblock copolymer, or PPO-PEO-PPO triblock copolymer), a random copolymer of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, polyoxyethylene styrenated phenyl ether, polyoxyethylene laurylamine, polyoxyethylene stearylamine, polyoxyethylene oleylamine, polyoxyethylene stearylamide, polyoxyethylene oleylamide, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylenesorbitan trioleate, polyoxyethylene sorbitol tetraoleate, polyoxyethylene castor oil, and polyoxyethylene hardened castor oil. Particularly preferable surfactants include a block copolymer of EO and PO (especially a PEO-PPO-PEO triblock copolymer), a random copolymer of EO and PO, and polyoxyethylene alkyl ether (e.g. polyoxyethylene decyl ether).

The surfactant typically has a molecular weight below 1 × 10⁴. From the standpoint of the ease of filtering the polishing composition and washing the polished article, it is preferably 9500 or smaller. The molecular weight of the surfactant is typically 200 or larger. From the standpoint of haze reduction effect, it is preferably 250 or larger, or more preferably 300 or larger (e.g. 500 or larger). As the molecular weight of the surfactant, the weight average molecular weight (Mw) determined by GPC (aqueous, based on standard polyethylene glycol) or the molecular weight determined from the chemical formula can be used.

More preferable molecular weight ranges of the surfactant may also vary depending on the type of surfactant. For instance, when a block copolymer of EO and PO is used as the surfactant, its Mw is preferably 1000 or larger, more preferably 2000 or larger, or yet more preferably 5000 or larger.

When the polishing composition disclosed herein comprises a surfactant, its content is not particularly limited as far as the effects of the present invention are not significantly impaired. Usually, from the standpoint of the washability, the surfactant content relative to 100 parts by mass of the abrasive is suitably 20 parts by mass or less, preferably 15 parts by mass or less, or more preferably 10 parts by mass or less (e.g. 6 parts by mass or less). From the standpoint of obtaining greater effects of using the surfactant, the surfactant content relative to 100 parts by mass of the abrasive is suitably 0.001 part by mass or greater, preferably 0.005 part by mass or greater, or more preferably 0.01 part by mass or greater (e.g. 0.05 part by mass or greater, typically 0.1 part by mass or greater).

The mass ratio (W1/W2) of water-soluble polymer content W1 to surfactant content W2 is not particularly limited. Usually, it is suitably in a range of 0.01 to 200, or preferably, for instance, in a range of 0.1 to 100. In a preferable embodiment, W1/W2 can be, for instance, in a range of 0.01 to 20, preferably in a range of 0.05 to 15, or more preferably in a range of 0.1 to 10.

### < Other components >

As far as the effects by the present invention are not significantly hindered, the polishing composition disclosed herein may further comprise as necessary known additives, such as chelating agents, organic acids, organic acid salts, inorganic acids, inorganic acid salts, preservatives, antifungal agents, and so on, which can be used in polishing compositions (typically, polishing compositions used for final polishing of silicon wafers).

Examples of chelating agents include aminocarboxylic acid-based chelating agents and organophosphonic acid-based chelating agents. Examples of aminocarboxylic acid-based chelating agents include ethylenediamine tetraacetic acid, ethylenediamine tetraacetic acid sodium salt, nitrilotriacetic acid, nitrilotriacetic acid sodium salt, nitrilotriacetic acid ammonium salt, hydroxyethylethylenedimaine triacetic acid, hydroxyethylethylenediamine triacetic acid sodium salt, diethylenetriamine pentaacetic acid, diethylenetriamine pentaacetic acid sodium salt, triethylenetetramine hexaacetic acid, and triethylenetetramine hexaacetic acid sodium salt. Examples of organophosphonic acid-based chelating agents include 2-aminoethylphosphonic acid, 1-hydroxyethylidene-1,1-diphosphonic acid, aminotri(methylenephosphonic acid), ethylenediaminetetrakis(methylenephosphonic acid), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and α-methylphosphonosuccinic acid. Among them, organophosphonic acid-based chelating agents are preferable, with ethylenediaminetetrakis(methylenephosphonic acid) and diethylenetriaminepenta(methylenephosphonic acid) being more preferable. A particularly preferable chelating agent is ethylenediaminetetrakis(methylenephosphonic acid).

Examples of organic acids include aliphatic acids such as formic acid, acetic acid, propionic acid; aromatic carboxylic acids such as benzoic acid, and phthalic acid; as well as citric acid, oxalic acid, tartaric acid, malic acid, maleic acid, fumaric acid, succinic acid, organic sulfonic acids, and organic phosphoric acids. Examples of organic acid salts include alkali metal salts (sodium salts, or potassium salts), and ammonium salts of organic acids. Examples of inorganic acids include sulfuric acid, nitric acid, hydrochloric acid, carbonic acid. Examples of inorganic acid salts include alkali metal salts (sodium salts, potassium salts) and ammonium salts of inorganic acids. The organic acids and their salts as well as inorganic acids and their salts can be used singly as one species or in a combination of two or more species.

Examples of preservatives and antifungal agents include isothiazoline-based compounds, paraoxybenzoic acid esters, and phynoxyethanol.

### < Applications >

The polishing composition disclosed herein can be suitably applied for polishing objects of various materials and shapes. The polishing object's material can be, for instance, a metal or metalloid such as silicon, aluminum, nickel, tungsten, copper, tantalum, titanium, stainless steel, or an alloy of these; a glassy material such as quartz glass, aluminosilicate glass, glassy carbon; a ceramic material such as alumina, silica, sapphire, silicon nitride, tantalum nitride, titanium carbide; material for compound semiconductor substrates such as silicon carbide, gallium nitride, gallium arsenide; a resin material such as polyimide resin. The polishing object may be formed of several materials among them. In particular, it is suitable for polishing a polishing object having a surface formed of silicon.

The shape of the polishing object is not particularly limited. The polishing composition disclosed herein can be preferably applied for polishing a polishing object having a flat surface such as a plate, or polyhedron.

The polishing composition disclosed herein can be preferably used for final polishing of a polishing object. Accordingly, this specification provides a polished article production method (e.g. silicon wafer production method) comprising a final polishing step using the polishing composition. The final polishing refers to the last polishing step (i.e. a step after which no further polishing is performed) in a production process of a polishing object of interest. The polishing composition disclosed herein may be used in an earlier polishing step than final polishing (referring to a step between the rough polishing step and final polishing step, typically including at least a first polishing step and possibly second, third ...polishing steps), for instance, in a polishing step performed just before final polishing.

The polishing composition disclosed herein can be particularly preferably used for polishing a silicon wafer. For instance, it is preferable as a polishing composition used in final polishing of a silicon wafer or in an earlier polishing step than this. For instance, it is effectively applied for polishing (typically final polishing or polishing just before this) of a silicon wafer prepared into a surface state having a surface roughness of 0.01 nm to 100 nm in an earlier step. It is particularly preferably applied to final polishing.

### < Polishing liquid >

The polishing composition disclosed herein is supplied to a polishing object, typically in a form of a polishing liquid comprising the polishing composition, and used for polishing the polishing object. The polishing liquid may be prepared, for instance, by diluting (typically with water) a polishing composition disclosed herein. Alternatively, the polishing composition can be used straight as a polishing liquid. In other words, the concept of polishing composition in the art disclosed herein encompasses both a polishing liquid (working slurry) supplied to a polishing object and used for polishing the polishing object and a concentrate (stock solution of polishing liquid) which is diluted for use as a polishing liquid. Other examples of the polishing liquid comprising the polishing composition disclosed herein include a polishing liquid obtained by adjusting the pH of the composition.

The abrasive content in the polishing liquid is not particularly limited. It is typically 0.01 % by mass or higher, preferably 0.05 % by mass or higher, or more preferably 0.1 % by mass or higher, for instance, 0.15 % by mass or higher. With increasing abrasive content, a higher polishing rate can be obtained. From the standpoint of obtaining a surface with lower haze, usually, the abrasive content is suitably 10 % by mass or lower, preferably 7 % by mass or lower, more preferably 5 % by mass or lower, or yet more preferably 2 % by mass or lower, for instance, 1 % by mass or lower.

The water-soluble polymer content in the polishing liquid is not particularly limited. For instance, it can be 1 × 10⁴ % by mass or higher. From the standpoint of haze reduction, the polymer content is preferably 5 × 10⁻⁴ % by mass or higher, or more preferably 1 × 10⁻³ % by mass or higher, for instance, 2 × 10⁻³ % by mass or higher. From the standpoint of the likelihood of forming grains in preferable sizes disclosed herein, the polymer content is preferably 0.2 % by mass or lower, or more preferably 0.1 % by mass or lower (e.g. 0.05 % by mass or lower).

When a surfactant is used, the surfactant content in the polishing liquid is not particularly limited. It is usually suitable that the surfactant content is 1 × 10⁻⁵ % by mass or higher (e.g. 1 × 10⁻⁴ % by mass or higher). From the standpoint of haze reduction, a preferable surfactant content is 5 × 10⁻⁵ % by mass or higher (e.g. 5 × 10⁻⁴ % by mass or higher), or more preferably 1 × 10⁻³ % by mass or higher, for instance, 2 × 10⁻³ % by mass or higher. From the standpoint of the washability, polishing rate, the surfactant content is preferably 0.2 % by mass or lower, or more preferably 0.1 % by mass or lower (e.g. 0.05 % by mass or lower).

When a basic compound is used, the basic compound content in the polishing liquid is not particularly limited. From the standpoint of increasing the polishing rate, usually, the basic compound content is preferably 0.001 % by mass or more of the polishing liquid, or more preferably 0.005 % by mass or more. From the standpoint of haze reduction, the basic compound content is preferably below 0.4 % by mass, or more preferably below 0.25 % by mass.

The pH of the polishing liquid is 9.0 to 11.0. It is preferable that the basic compound is contained to yield such a pH of the polishing liquid. The above-described pH can be preferably applied to a polishing liquid (e.g. polishing liquid for final polishing) used for polishing a silicon wafer.

### < Grains in polishing composition >

The polishing composition disclosed herein may comprise, as grains, simple abrasive grains or grains formed by adhesion of the abrasive and water-soluble polymer. The grain may be, for instance, in a form of an abrasive grain or a single abrasive grain bearing one or several polymer molecules on the surface thereof, in a form of a single polymer molecule bearing two or more abrasive grains adhered to the surface thereof, in a form of two or more abrasive grains adhered to two or more polymer molecules, in a form of the abrasive and water-soluble polymer further bearing other components) (e.g. surfactant) of the polishing composition, and so on. Generally, in the polishing composition used for polishing a polishing object, grains in several forms as exemplified above are thought to be present as a mixture. The presence of grains formed by adhesion of the abrasive and water-soluble polymer in the polishing composition can be detected when the average particle diameter measured for the grains in the polishing composition is larger than the average particle diameter of the abrasive grain.

The sizes of grains in the polishing liquid (working slurry) supplied to a polishing object can be determined, for instance, by conducting particle size analysis based on dynamic light scattering, using a measurement sample of the polishing liquid. The particle size analysis can be performed, for instance, using model "UPA-UT151" available from Nikkiso Co., Ltd. According to the studies by the present inventors, by using a polishing liquid for which the particle size analysis yields a volume average particle diameter D_{A} of a prescribed value or smaller (specifically 60 nm or smaller), as compared with an embodiment using a polishing liquid with a larger D_{A}, the number of micro defects (e.g. the number of micro defects detected by the micro defect inspection described later in the working examples) can be significantly reduced.

The lower limit of volume average particle diameter D_{A} is not particularly limited from the standpoint of reducing the number of micro defects. From the standpoint of the effects of polishing (e.g. effects such as reduced haze, removal of defects), the D_{A} is suitably 20 nm or larger, or preferably 30 nm or larger. From the standpoint of balancing micro defect reduction and effects of polishing at a higher level, the D_{A} is preferably 35 nm or larger, more preferably 40 nm or larger, or yet more preferably 45 nm or larger. In a preferable embodiment of the art disclosed herein, the D_{A} can be 50 nm or larger (typically larger than 50 nm). A polishing liquid that satisfies such a D_{A} may efficiently bring about a polished surface that has achieved particularly high levels of reduction of both micro defects and haze.

The volume average particle diameter D_{A} can be adjusted to a desirable numerical range, for instance, by the selection of an abrasive (sizes (D_{P1}, D_{P2}), shape, or size distribution); selection of a water-soluble polymer (composition, Mw, Mw/Mn, or molecular structure); amount of the water-soluble polymer used relative to the abrasive; use/non-use of a surfactant as well as selection of the type and amount, when used. The same applies to the particle size distribution of the grains described later.

The D_{A} can be measured, as described above, with the measurement sample being the polishing composition at a concentration actually employed when supplying it to a polishing object. In general, even if the NV is varied in a range of about 0.05 to 5 % by mass while keeping the ratio of the respective components constant, the D_{A} value will not change greatly. Thus, practically, when the D_{A} value measured at a concentration equivalent to 0.2 % (by mass) abrasive content (i.e. the D_{A} value obtained, using the polishing composition at the aforementioned concentration as the measurement sample) is in the range, the aforementioned effects can be attained not only when using the polishing composition as a polishing liquid at 0.2 % (by mass) abrasive content, but also when using the polishing composition at a different abrasive content (e.g. in the range between about 0.05 and 5 % by mass, but different from 0.2 % by mass).

It is desirable that the pH of the measurement sample is not significantly different from the pH of the actual polishing composition (polishing liquid) supplied to a polishing object. For instance, D_{A} is preferably measured for a measurement sample at pH 9.0 to 11.0, typically about pH 10.0 to 10.5. The pH range can be preferably applied to, for instance, a polishing composition for use in final polishing of silicon wafers.

To practice the art disclosed herein, it is unnecessary to reveal how satisfying the D_{A} solves the aforementioned problem. However, it may be considered as follows: In particular, larger grains (which can be the abrasive alone, abrasive with surrounding water-soluble polymer adhered thereto, abrasive/water-soluble polymer assemblies) in the polishing composition cause greater damage to the surface being polished, leading to a tendency for the occurrence of defects. The presence of rough grains may lead to uneven polishing, impairing the surface smoothness. Moreover, since rough grains have many points in contact or proximity with the surface of the polishing object (i.e. areas readily available for interactions between the two), they tend to stay on the polishing object's surface for a long time and are likely to remain on the polished surface after completion of the polishing. The remaining grains can be washed off. However, from the start of wash to the elimination of grains, on the polished surface, grain-bearing areas are less susceptible than the other areas to etching by the wash solution and thus remain as higher areas (protrusions) than the surrounding areas on the washed surface. These can be detected as micro defects (PID).

According to the art disclosed herein, by limiting the grain size of the polishing liquid to not become excessively large based on the volume average particle diameter D_{A}, fewer grains remain on the polished surface or remaining grains are likely eliminated in an earlier stage of the wash (thus while there is no significant difference in the etched amount when compared with the surroundings). This is thought to contribute to reduce micro defects. In particular, from the standpoint of reducing the haze, an abrasive (e.g. an abrasive having an average primary particle diameter D_{P1} of smaller than 35 µm (particularly 30 nm or smaller) or an average secondary particle diameter D_{P2} of 65 µm or smaller (particularly 60 µm or smaller)) that is size-wise smaller than a conventional general abrasive can be more advantageous than an abrasive of a conventional size, but the behavior of abrasive grains in the polishing liquid are prone to the influence of the water-soluble polymer adhered to the grains. Thus, it is particularly meaningful to limit the grain size by applying the art disclosed herein.

The relationship between the volume average particle diameter D_{A} of the grains in the polishing composition and the abrasive's average secondary particle diameter D_{P2} theoretically satisfies D_{A/}D_{P2} ≥ 1 and is typically D_{A/}D_{P2} > 1. From the standpoint of greater reduction of micro defects, D_{A}/D_{P2} is preferably 2.00 or less, more preferably 1.50 or less, or yet more preferably 1.30 or less.

The relationship between the volume average particle diameter D_{A} of the grains in the polishing composition and the abrasive's average primary particle diameter D_{P1} theoretically satisfies D_{A}/D_{P1} ≥ 1 and is typically D_{A}/D_{P1} > 1. Although not particularly limited, from the standpoint of haze reduction, D_{A}/D_{P1} is preferably 1.30 or higher, or more preferably 1.50 or higher. From the standpoint of haze reduction, D_{A}/D_{P1} is preferably 5.00 or lower, more preferably 3.00 or lower, or yet more preferably 2.50 or lower.

Although not particularly limited, with respect to the polishing composition, in the volume-based size distribution of the grains determined by dynamic light scattering at a concentration equivalent to 0.2 % (by mass) abrasive content, the ratio (D95/D50) of 95th percentile diameter D95 to 50th percentile diameter D50 is preferably 3.00 or lower, or more preferably 2.00 or lower (e.g. 1.80 or lower). Because there are fewer rough grains, such a composition causes fewer defects. Since the grain size distribution is narrow, there is little variation in the washability of the grains remaining on the polished surface. Thus, without making the wash conditions extremely harsh, the residue on the surface can be washed off more precisely. This can bring about a surface of higher quality. The lower limit of D95/D50 is theoretically 1. From the standpoint of the dispersion stability and ease of preparation of the polishing composition, D95/D50 is suitably 1.20 or higher, preferably 1.30 or higher, or more preferably 1.40 or higher (e.g. 1.45 or higher).

Although not particularly limited, the polishing composition disclosed herein can be preferably made in an embodiment where the grains has a ratio of D95 (95th percentile diameter) to D10 (10th percentile diameter), D95/D10, of 4.00 or lower. D95/D10 is preferably 3.00 or lower, or more preferably 2.50 or lower. The lower limit of D95/D 10 is theoretically 1. From the standpoint of the dispersion stability and ease of preparation of the polishing composition, D95/D 10 is suitably 1.50 or higher, or preferably 1.80 or higher (e.g. 2.00 or higher).

There are no particular limitations to each of D50, D95 and D10 of the grains in the polishing composition as far as they can bring about a preferable size distribution disclosed herein. It is noted that D10, D50 and D95 are theoretically in a relationship of D10 ≤ D50 ≤ D95.

From the standpoint of the polishing rate, D50 is preferably larger than 10 nm, or more preferably larger than 20 nm. From the standpoint of obtaining greater polishing effects, D50 is preferably 30 nm or larger, or more preferably 35 nm or larger. From the standpoint of the likelihood of achieving a smoother surface (e.g. surface with lower haze), D50 is suitably 90 nm or smaller, preferably 80 nm or smaller, or more preferably 70 nm or smaller.

From the standpoint of the polishing rate, D95 is preferably 50 nm or larger, or more preferably 60 nm or larger (e.g. 65 nm or larger). From the standpoint of reducing scratches, D95 is suitably 120 nm or smaller, preferably 110 nm or smaller, or more preferably 100 nm or smaller.

D10 is typically 10 nm or larger. From the standpoint of the efficiency of polishing, it is suitably 20 nm or larger. From the standpoint of the ease of preparation of the polishing composition, D10 is suitably smaller than 60 nm, or preferably smaller than 50 nm.

Although not particularly limited, the polishing composition disclosed herein can be preferably made in an embodiment where the difference between the volume average particle diameter D_{A} of the grains and the abrasive's average secondary particle diameter D_{P2} is 20 nm or less. More preferably, D_{A}-D_{P2} (i.e. the value of D_{A} minus D_{P2}) is 15 nm or less (typically 0 to 15 nm). A polishing composition with a small D_{A}-D_{P2} (i.e. with no excessive change in volume average particle diameter due to adhesion of the abrasive and water-soluble polymer) is preferable since it tends to have a smaller presence of rough grains. Such a polishing composition can bring about a polished surface of higher quality.

Although not particularly limited, in the polishing composition disclosed herein, the ratio (D_{A}/D50) of volume average particle diameter D_{A} to 50th percentile diameter D50 of the grains is preferably 1.40 or lower (e.g. 1.20 or lower). A polishing composition with a small value of the ratio (D_{A}/D50) is preferable because it has fewer rough grains. The lower limit of D_{A}/D50 is theoretically 1.

< Preparation of polishing composition >

The polishing composition disclosed herein can be produced by a suitable method that allows formation of a polishing composition that satisfies the desirable D_{A}. For instance, the respective components of the polishing composition can be mixed, using a commonly known mixing device such as a propeller stirrer, ultrasonic disperser, homo mixer. The way of mixing these components is not particularly limited. For instance, all the components can be mixed at once or in a suitably selected order.

Although not particularly limited, from the standpoint of the consistent (reproducible) production of polishing compositions satisfying desirable D_{A} values, for instance, the following production method can be preferably employed for the basic compound-containing polishing composition.

The polishing composition production method disclosed herein can be preferably applied for producing a polishing composition (as its target product) comprising an abrasive, a water-soluble polymer, a basic compound and water, wherein the polishing composition comprising the abrasive, aggregates formed of the abrasive and water-soluble polymer as grains, wherein the grains have a volume average particle diameter D_{A} of 20 nm to 60 nm when measured by dynamic light scattering at a concentration equivalent to 0.2 % (by mass) abrasive content. In the production method, a dispersion comprising an abrasive (e.g. silica grains), a basic compound and water (or "basic abrasive dispersion" hereinafter) is obtained and the basic abrasive dispersion and a water-soluble polymer are mixed.

In such a basic abrasive dispersion containing both the abrasive and basic compound, the abrasive exhibits greater electrostatic repulsion due to the basic compound and thus shows higher dispersion stability than an abrasive dispersion free of a basic compound (which is typically almost neutral). Accordingly, local aggregation of the abrasive is less likely to occur as compared with an embodiment where the basic compound is added after addition of the water-soluble polymer to a neutral abrasive dispersion and an embodiment where the neutral abrasive dispersion, water-soluble polymer and basic compound are mixed all at once. Thus, according to the method where the water-soluble polymer is mixed in the basic abrasive dispersion, adhesion of the abrasive and water-soluble polymer is allowed to develop evenly, allowing for consistent (reproducible) production of polishing compositions satisfying desirable D_{A} values.

The water-soluble polymer is preferably pre-dissolved in water and mixed in the form of an aqueous solution (or "aqueous polymer solution" hereinafter) with the basic abrasive dispersion. This can better inhibit local aggregation of the abrasive, whereby adhesion of the abrasive and water-soluble polymer is allowed to develop more evenly.

When mixing the basic abrasive dispersion and aqueous polymer solution, it is preferable to add the aqueous polymer solution to the basic abrasive dispersion. According to such a mixing method, adhesion of the abrasive and water-soluble polymer is allowed to develop more evenly, for instance, as compared with a mixing method where the basic abrasive dispersion is added to the aqueous polymer solution. When the abrasive is silica grains (e.g. colloidal silica grains), it is particularly meaningful to use the mixing method by which an aqueous polymer solution is added to a basic abrasive dispersion as described above.

Among the abrasive, water-soluble polymer, basic compound and water forming the polishing composition to be produced, the basic abrasive dispersion comprises at least some of the abrasive, at least some of the basic compound and at least some of the water. For instance, in a preferable embodiment, the abrasive dispersion comprises all the abrasive forming the polishing composition, at least some of the basic compound and at least some of the water.

The basic compound content in the basic abrasive dispersion is preferably 0.01 % by mass or greater, more preferably 0.05 % by mass or greater, or yet more preferably 0.1 % by mass or greater. With increasing basic compound content, there is a tendency for greater inhibition of the occurrence of local aggregation during preparation of the polishing composition. The basic compound content in the basic abrasive dispersion is preferably 10 % by mass or less, more preferably 5 % by mass or less, or yet more preferably 3 % by mass or less. A lower basic compound content facilitates adjustment of the basic compound content in the polishing composition.

The basic abrasive dispersion has a pH of preferably 8 or higher, or more preferably 9 or higher. With increasing pH, there is a tendency for greater inhibition of the occurrence of local aggregation when the water-soluble polymer or an aqueous solution thereof is added to the basic abrasive dispersion. Thus, it allows adhesion of the abrasive and water-soluble polymer to develop more evenly, leading to more consistent production of polishing compositions satisfying the desirable D_{A}. The pH of the basic abrasive dispersion is preferably 12 or lower, more preferably 11.5 or lower, or yet more preferably 10.5 or lower. With the pH of the basic abrasive dispersion being lower in the basic range, the amount of the basic compound required for preparing the dispersion is reduced, making it easier to adjust the basic compound content in the polishing composition. For instance, when the abrasive is silica grains, it is advantageous that the pH is not excessively high also from the standpoint of reducing dissolution of the silica. The mixture's pH can be adjusted by modifying the amount of the basic compound added.

Such a basic abrasive dispersion can be prepared by mixing an abrasive, a basic compound and water. They can be mixed with a commonly known mixing device such as a propeller stirrer, ultrasonic disperser, homo mixer. The mode of mixing the respective components of the basic abrasive dispersion is not particularly limited. For instance, the components can be mixed all at once or in a suitably selected order. An example of preferable embodiments is an embodiment where an approximately neutral dispersion comprising the abrasive and water is mixed with the basic compound or an aqueous solution thereof.

When mixing the water-soluble polymer in a form of an aqueous solution (aqueous polymer solution) into a basic abrasive dispersion, the water-soluble polymer content in the aqueous polymer solution is preferably 0.02 % by mass or greater, more preferably 0.05 % by mass or greater, or yet more preferably 0.1 % by mass or greater. With increasing water-soluble polymer content, it becomes easier to adjust the water-soluble polymer content in the polishing composition. The water-soluble polymer content in the aqueous polymer solution is preferably 10 % by mass or less, more preferably 5 % by mass or less, or yet more preferably 3 % by mass or less. With decreasing water-soluble polymer content, local aggregation of the abrasive tends to be more likely reduced when mixing the aqueous polymer solution with the basic abrasive dispersion.

The pH of the aqueous polymer solution is adjusted preferably to around neutral to basic, or more preferably to basic. More specifically, the pH of the aqueous polymer solution is preferably 8 or higher, or more preferably 9 or higher. The pH can be adjusted by using some of the basic compound forming the polishing composition. The increased pH of the aqueous polymer solution can more greatly reduce local aggregation of the abrasive when the aqueous polymer solution is added to the basic abrasive dispersion. This allows adhesion of the abrasive and water-soluble polymer to develop more evenly, leading to more consistent production of polishing compositions satisfying the desirable D_{A}. The pH of the aqueous polymer solution is preferably 12 or lower, or more preferably 10.5 or lower. When the pH of the aqueous polymer solution is lower in the basic range, the amount of the basic compound required for preparing the aqueous polymer solution is reduced, making it easier to adjust the basic compound content in the polishing composition. For instance, when the abrasive is silica grains, it is advantageous that the pH is not excessively high also from the standpoint of reducing dissolution of the silica.

The rate of adding the aqueous polymer solution to the basic abrasive dispersion (supply rate) is preferably, with respect to 1 L of the dispersion, at or below 500 mL of aqueous polymer solution per minute, more preferably at or below 100 mL/min, or yet more preferably at or below 50 mL/min. With decreasing supply rate, local aggregation of the abrasive can be more greatly reduced.

In a preferable embodiment, the aqueous polymer solution can be filtered before added to the basic abrasive dispersion. By filtering the aqueous polymer solution, the amounts of contaminants and aggregates in the aqueous polymer solution can be reduced. This allows adhesion of the abrasive and water-soluble polymer to develop more evenly, leading to more consistent production of polishing compositions satisfying the desirable D_{A}.

The filtration method is not particularly limited. Known filtration methods can be suitably employed such as natural filtration performed at normal pressure as well as suction filtration, pressure filtration, centrifugal filtration. The filter used for filtration is preferably selected based on mesh size. From the standpoint of the productivity of polishing compositions, the filter's mesh size is preferably 0.05 µm or larger, more preferably 0.1 µm or larger, or yet more preferably 0.2 µm or larger. From the standpoint of increasing the effect of eliminating contaminants and aggregates, the filter's mesh size is preferably 100 µm or smaller, more preferably 70 µm or smaller, or yet more preferably 50 µm or smaller. The filter's material or construction is not particularly limited. Examples of the filter's material include cellulose, nylon, polysulfone, polyether sulfone, polypropylene, polytetrafluoroethylene (PTFE), polycarbonate, glass. Examples of the filter's construction include depth, pleated, membrane.

The polishing composition production method described above can be applied when the polishing composition obtainable by mixing the basic abrasive dispersion and the water-soluble polymer or an aqueous solution thereof is a polishing liquid (working slurry) or has approximately the same NV as this as well as when it is a concentrate described later. Even when the basic abrasive dispersion and the water-soluble polymer or an aqueous solution thereof are mixed to obtain a concentrate and the concentrate is diluted to prepare a polishing liquid, by applying the aforementioned procedure in preparing the concentrate (i.e. the procedure of first obtaining the basic abrasive dispersion comprising the abrasive and basic compound and then mixing therewith the water-soluble polymer or an aqueous solution thereof), adhesion of the abrasive and water-soluble polymer are allowed to develop evenly. By diluting the concentrate thus prepared, it is possible to consistently (reproducibly) produce polishing liquids satisfying the desirable D_{A}.

### < Polishing >

The polishing composition disclosed herein can be preferably used for polishing a polishing object, for instance, in an embodiment comprising operations described below. A preferable embodiment of the method for polishing a polishing object using a polishing composition disclosed herein is described below.

In particular, a polishing slurry comprising a polishing composition disclosed herein is obtained. As described above, obtaining the polishing slurry may comprise preparing a polishing slurry by subjecting the polishing composition to concentration adjustment (e.g. dilution), pH adjustment and so on. Alternatively, a polishing composition may be used as is as the polishing slurry.

Subsequently, the polishing slurry is supplied to a polishing object and polishing is carried out by a conventional method. For instance, when carrying out final polishing of a silicon wafer, the silicon wafer after a lapping step and first polishing step is set in a general polishing machine and via a polishing pad in the polishing machine, the polishing slurry is supplied to the surface (surface to be polished) of the silicon wafer. Typically, while the polishing slurry is continuously supplied, the polishing pad is pushed against the surface of the silicon wafer, and the two are moved (e.g. moved in circular motion) in coordination. Via such a polishing step, polishing of the polishing object is completed.

A polishing step such as the above may be part of production processes of polished articles (e.g. substrates such as silicon wafers). Accordingly, this specification provides a method for producing a polished article (preferably, a method for producing a silicon wafer), with the method comprising the polishing step.

In a preferable embodiment of the polished article production method disclosed herein, as the polishing liquid supplied to the polishing object in the polishing step, it can be preferable to use a polishing liquid comprising an abrasive, a water-soluble polymer and water, having a volume average particle diameter D_{A} of grains (such as the abrasive and aggregates formed of the abrasive and the water-soluble polymer) of 20 nm to 60 nm when measured by dynamic light scattering. The abrasive content in the polishing liquid is not particularly limited and can be, for instance, about 0.05 % by mass to 5 % by mass. In other words, the polished article production method disclosed herein can be preferably practiced in an embodiment where the volume average particle diameter D_{A} measured for the polishing liquid to be actually supplied to a polishing object is within the range given above. According to such an embodiment, a polished article (e.g. silicon wafer) can be produced with particularly effectively reduced occurrence of micro defects.

The polishing pad(s) used in the polishing step using a polishing liquid comprising the polishing composition disclosed herein are not particularly limited. For instance, any of the non-woven fabric type, suede type, abrasive-bearing type, abrasive-free type, can be used.

### < Wash >

The polishing object polished with the polishing composition disclosed herein is typically washed after polished. The wash can be carried out, using a suitable wash solution. The wash solution used is not particularly limited. Usable examples include SC-1 wash solution (a mixture of ammonium hydroxide (NH₄OH), hydrogen peroxide (H₂O₂) and water (H₂O); washing with SC-1 wash solution is referred to as "SC-1 washing" hereinafter), SC-2 wash solution (a mixture of HCl, H₂O₂ and H₂O) generally used in the field of semiconductors. The temperature of the wash solution can be, for instance, room temperature to about 90 °C. From the standpoint of increasing the washing efficiency, a wash solution at about 50 °C to 85 °C can be preferably used.

### < Concentrate >

The polishing composition disclosed herein may be in a concentrated form (i.e. in a form of a concentrate of the polishing liquid) before supplied to a polishing object. The polishing composition in a concentrated form as this is advantageous from the standpoint of the convenience and cost reduction for production, distribution, storage. The concentration can be, for instance, about 2-fold to 100-fold by volume while it is usually suitably about 5-fold to 50-fold. The concentration of the polishing composition according to a preferable embodiment is 10-fold to 30-fold, for instance, 15-fold to 25-fold.

The polishing composition in a concentrate form as this can be used in an embodiment where it is diluted whenever desired to prepare a polishing liquid and the polishing liquid is supplied to a polishing object. The dilution can be carried out typically by adding and mixing an aforementioned aqueous solvent with the concentrate. When the aqueous solvent is a solvent mixture, the dilution can be performed by adding just some of the components of the aqueous solvent or by adding a solvent mixture comprising the components at a mass ratio different from that of the aqueous solvent.

The concentrate can have an NV of, for instance, 50 % by mass or lower. From the standpoint of the stability (e.g. dispersion stability of the abrasive) and ease of filtration of the polishing composition, usually, the concentrate has an NV of suitably 40 % by mass or lower, preferably 30 % by mass or lower, or yet more preferably 20 % by mass or lower, for instance, 15 % by mass or lower. From the standpoint of the convenience and cost reduction for production, distribution, storage and so on, the NV of the concentrate is suitably 0.5 % by mass or higher, preferably 1 % by mass or higher, or more preferably 3 % by mass or higher, for instance, 5 % by mass or higher.

The abrasive content in the concentrate can be, for instance, 50 % by mass or lower. From the standpoint of the stability (e.g. dispersion stability of the abrasive) and ease of filtration of the polishing composition, usually, the abrasive content is preferably 45 % by mass or lower, or more preferably 40 % by mass or lower. In a preferable embodiment, the abrasive content can be 30 % by mass or lower, or even 20 % by mass or lower (e.g. 15 % by mass or lower). From the standpoint of the convenience and cost reduction for production, distribution, storage and so on, the abrasive content can be, for instance, 0.5 % by mass or higher, preferably 1 % by mass or higher, or more preferably 3 % by mass or higher (e.g. 5 % by mass or higher).

The water-soluble polymer content in the concentrate can be, for instance, 3 % by mass or lower. From the standpoint of the ease of filtration and washability of the polishing composition, usually, the water-soluble polymer content is preferably 1 % by mass or lower, or more preferably 0.5 % by mass or lower. From the standpoint of the convenience and cost reduction for production, distribution, storage and so on, the water-soluble polymer content is usually suitably 1 × 10⁻³ or higher, preferably 5 × 10⁻³ or higher, or more preferably 1 × 10⁻² or higher.

The polishing composition disclosed herein may be of a one-pack type or a multiple-pack type such as two-pack types. For example, it may be formulated such that liquid A including some of the components (typically, some of the components other than the aqueous solvent) of the polishing composition and liquid B including other components are mixed and the mixture is used for polishing of a polishing object. The art disclosed herein can be preferably implemented in an embodiment of, for instance, a one-pack type polishing composition.

Several worked examples relating to the present invention are described below. In the description below, "parts" and "%" are based on mass unless otherwise specified.

### < Preparation of polishing compositions >

### (Example 1)

Was obtained a colloidal silica dispersion containing 20 % colloidal silica as the abrasive and adjusted to pH 9.0 by adding ammonia water containing 29 % ammonia (NH₃) as the basic compound. The colloidal silica had an average primary particle diameter of 23 nm and an average secondary particle diameter of 45 nm. The average primary particle diameter was measured with a surface area analyzer under trade name "FLOW SORB II 2300" available from Micromeritics Instrument Corporation. The average secondary particle diameter is the volume average secondary particle diameter measured for the colloidal silica dispersion as the measurement sample, using model "UPA-UT151" available from Nikkiso Co., Ltd. (The same applies to the examples below).

To the colloidal silica dispersion, ammonia water was further added to prepare a basic dispersion at pH 10.3. Was obtained an aqueous polymer solution containing 1.5 % hydroxyethyl cellulose (Mw 25 × 10⁴; or "HEC-A" hereinafter) and adjusted to pH 9.0 with ammonia. The aqueous polymer solution was added and mixed into the basic dispersion. Ultrapure water was further added to prepare a polishing composition concentrate with 3.5 % abrasive content. The concentrate was diluted with ultrapure water to 0.2 % abrasive content to prepare a polishing liquid having the composition shown in Table 1. The amounts of water-soluble polymer and ammonia water used were adjusted so that the polishing liquid had 0.010 % water-soluble polymer and 0.005 % ammonia (5 parts and 2.5 parts, respectively, to 100 parts of abrasive). The resulting polishing liquid had a pH of 10.1.

The polishing liquid (0.2 % abrasive content) thus obtained was subjected as a measurement sample to particle size analysis based on dynamic light scattering, using model "URA-UT151" available from Nikkiso Co., Ltd. As a result, the grains in the measurement sample were found to have a volume average particle diameter D_{A} of 56 nm. Table 1 shows the composition of the polishing liquid as well as the measured values of the abrasive's average primary and secondary particle diameters D_{P1} and D_{P2} and the volume average particle diameter D_{A} of the grains in the measurement sample (The same applies to the examples below).

### (Example 2)

In place of the aqueous polymer solution in Example 1, were used an aqueous polymer solution containing 1.5 % HEC-A and adjusted to pH 9.0 with ammonia and an aqueous surfactant solution. As the surfactant, a PEO-PPO-PEO block copolymer (Mw 9000) was used. The amount used was adjusted to 0.001 % of the polishing liquid (0.5 part to 100 parts of abrasive). Otherwise, in the same manner as Example 1, was prepared a polishing liquid having the composition shown in Table 1. Measured in the same manner as Example 1, the grains had a volume average particle diameter D_{A} of 57 nm.

### (Example 3)

The HEC-A concentration in the aqueous polymer solution used was changed to 0.5 times that in Example 2. Otherwise, in the same manner as Example 2, was prepared a polishing liquid having the composition shown in Table 1. Measured in the same manner as Example 1, the grains had a volume average particle diameter D_{A} of 57 nm.

### (Example 4)

The HEC-A concentration in the aqueous polymer solution used was changed to 1.5 times that in Example 2. Otherwise, in the same manner as Example 2, was prepared a polishing liquid having the composition shown in Table 1. Measured in the same manner as Example 1, the grains had a volume average particle diameter D_{A} of 58 nm.

### (Example 5)

Was used an aqueous polymer solution containing 2 % polyvinyl alcohol (Mw 1.3 × 10⁴, degree of saponification ≥ 95 % by mole; or "PVA-1" hereinafter) in place of HEC-A in Example 2. Otherwise, in the same manner as Example 2, was prepared a polishing liquid having the composition shown in Table 1. Measured in the same manner as Example 1, the grains had a volume average particle diameter D_{A} of 46 nm.

### (Comparative Example 1)

To a pH 9.0 colloidal silica dispersion containing 20 % colloidal silica (35 nm average primary particle diameter, 66 nm average secondary particle diameter) as the abrasive, was added ammonia water containing 29 % ammonia (NH₃) as the basic compound to prepare a basic dispersion at pH 10.3. Was obtained an aqueous polymer solution containing 1.5 % HEC-A and adjusted to pH 9.0 with ammonia. The aqueous polymer solution was added and mixed into the basic dispersion. Ultrapure water was further added to prepare a polishing composition concentrate with 9.2 % abrasive content. The concentrate was diluted with ultrapure water to 0.5 % abrasive content to prepare a polishing liquid having the composition shown in Table 1. The amounts of the water-soluble polymer and ammonia water used were adjusted so that the water-soluble polymer and ammonia contents per unit surface area of abrasive per unit volume of polishing liquid were approximately the same as those in the polishing liquid of Example 1. Specifically, their amounts were adjusted so that their contents (concentrations) in the polishing liquid were 0.020 % and 0.010 %, respectively.

The polishing liquid was further diluted with ultrapure water to 0.2 % abrasive content. This was subjected as a measurement sample to particle size analysis based on dynamic light scattering, using model "UPA-UT151" available from Nikkiso Co., Ltd. As a result, the grains in the measurement sample were found to have a volume average particle diameter D_{A} of 80 nm.

### (Comparative Example 2)

In place of the aqueous polymer solution in Comparative Example 1, were used an aqueous polymer solution containing 1.5 % HEC-Aand adjusted to pH 9.0 with ammonia and an aqueous surfactant solution. As the surfactant, a PEO-PPO-PEO block copolymer (Mw 9000) was used in an amount equivalent to 0.002 % of the polishing liquid. Otherwise, in the same manner as Comparative Example 1, a polishing liquid having the composition shown in Table 1 was prepared. Measured in the same manner as Comparative Example 1, the grains had a volume average particle diameter D_{A} of 72 nm.

### (Comparative Example 3)

To a pH 9.0 colloidal silica dispersion containing 20 % colloidal silica (12 nm average primary particle diameter, 28 nm average secondary particle diameter) as the abrasive, was added ammonia water containing 29 % ammonia (NH₃) as the basic compound to prepare a basic dispersion at pH 10.3. To this basic dispersion, were added a pH 7.0 aqueous polymer solution containing 1 % hydroxyethyl cellulose with Mw of 100 × 10⁴ (or "HEC-B" hereinafter) and an aqueous surfactant solution. As the surfactant, a PEO-PPO-PEO block copolymer (Mw 9000) was used. Ultrapure water was further added to prepare a polishing composition concentrate with 3.5 % abrasive content. The concentrate was diluted with ultrapure water to 0.2 % abrasive content to prepare a polishing liquid having the composition shown in Table 1. Measured in the same manner as Example 1, the grains had a volume average particle diameter D_{A} of 65 nm.

### (Comparative Example 4)

In place of HEC-A in Example 2, HEC-B was used. Otherwise, in the same manner as Example 2, was prepared a polishing liquid having the composition shown in Table 1. Measured in the same manner as Example 1, the grains had a volume average particle diameter D_{A} of 71 nm.

### (Comparative Example 5)

To a pH 9.0 colloidal silica dispersion containing 20 % colloidal silica (35 nm average primary particle diameter, 66 nm average secondary particle diameter) as the abrasive, was added ammonia water containing 29 % ammonia (NH₃) as the basic compound to prepare a basic dispersion at pH 10.3. To this basic dispersion, were added a pH 7.0 aqueous polymer solution containing 1 % HEC-B and an aqueous surfactant solution. As the surfactant, a PEO-PPO-PEO block copolymer (Mw 9000) was used. Ultrapure water was further added to prepare a polishing composition concentrate with 9.2 % abrasive content. The concentrate was diluted with ultrapure water to 0.5 % abrasive content to prepare a polishing liquid having the composition shown in Table 1. Measured in the same manner as Comparative Example 1, the grains had a volume average particle diameter D_{A} of 90 nm.

### (Example 6)

As the water-soluble polymer, was used a polyacryloylmorpholine with Mw of 7 × 10⁴ (or "PACMO-1" hereinafter). Otherwise, in the same manner as Example 2, was prepared a polishing liquid having the composition shown in Table 2. Measured in the same manner as Example 1, the grains had a volume average particle diameter D_{A} of 48 nm.

### (Example 7)

As the water-soluble polymer, was used a polyvinyl alcohol with Mw of 1.3 × 10⁴ (80 % by mole vinyl alcohol unit, 20 % by mole vinyl hexanoate unit; or "PVA-2" hereinafter). Otherwise, in the same manner as Example 2, was prepared a polishing liquid having the composition shown in Table 2. Measured in the same manner as Example 1, the grains had a volume average particle diameter D_{A} of 46 nm.

### (Example 8)

As the water-soluble polymer, was used a polyvinyl alcohol with Mw of 0.5 × 10⁴ (80 % by mole vinyl alcohol unit, 20 % by mole vinyl hexanoate unit; or "PVA-3" hereinafter). Otherwise, in the same manner as Example 2, was prepared a polishing liquid having the composition shown in Table 2. Measured in the same manner as Example 1, the grains had a volume average particle diameter D_{A} of 46 nm.

### (Example 9)

As the water-soluble polymer, were used PVA-3 and a polyvinylpyrrolidone with Mw of 6 × 10⁴ (PVP). Otherwise, in the same manner as Example 2, a polishing liquid having the composition shown in Table 2 was prepared. Measured in the same manner as Example 1, the grains had a volume average particle diameter D_{A} of 46 nm.

### (Example 10)

As the water-soluble polymer, were used HEC-A and a polyacryloylmorpholine with Mw of 8 × 10⁴ (or "PACMO-2" hereinafter). Otherwise, in the same manner as Example 2, was prepared a polishing liquid having the composition shown in Table 2. A measurement sample adjusted by dilution to 0.2 % abrasive content was measured in the same manner as Comparative Example 1 and the grains were found to have a volume average particle diameter D_{A} of 51 nm.

### (Example 11)

As the water-soluble polymer, were used HEC-A and PVP. Otherwise, in the same manner as Example 2, was prepared a polishing liquid having the composition shown in Table 2. A measurement sample adjusted by dilution to 0.2 % abrasive content was measured in the same manner as Comparative Example 1 and the grains were found to have a volume average particle diameter D_{A} of 50 nm.

### < Silicon Wafer Polishing >

Silicon wafer surfaces were polished with the polishing compositions according to the respective examples under the conditions shown below. The silicon wafers used had 300 mm diameter, p-type conductivity, crystal orientation of <100> and a resistivity of 0.1 Ω·cm or greater, but less than 100 Ω·cm, and were preliminarily polished with a polishing slurry (trade name "GLANZOX 2100" available from Fujimi Inc.) to a surface roughness of 0.1 nm to 10 nm for the use.

### [Polishing Conditions]

Polishing machine: Sheet-type polisher with model number "PNX-332B" available from Okamoto Machine Tool Works, Ltd.

Polishing tables: Using two rear tables among three tables of the polishing machine, the first and second stages of final polishing after the preliminary polishing were carried out.

### (The conditions below were common between the two tables)

Polishing pressure: 15kPa
Plate rotational speed: 30 rpm
Head rotational speed: 30 rpm
Polishing time: 2 min
Temperature of polishing liquid: 20 °C
Flow rate of polishing liquid: 2.0 L/min (drain)

### < Wash >

Polished silicon wafers were washed (SC-1 washed) with a wash solution at NH₄OH (29%)/H₂O₂ (31%)/deionized water (DIW) = 1/3/30 (volume ratio). More specifically, two washing baths each equipped with an ultrasonic wave oscillator of 950 kHz frequency were obtained; the wash solution was placed in each of the first and second washing baths and maintained at 60 °C; and each polished silicon wafer was immersed in the first washing bath for 6 minutes and then, via a ultrasonic rinsing bath with ultrapure water, in the second washing bath for 6 minutes, with the respective ultrasonic wave oscillators turned on.

### < Micro defect Inspection >

The surfaces of the respective washed silicon wafers were inspected with a wafer inspection system under trade name "MAGICS M5350" available from Lasertec Corporation. Table 1 and Table 2 show the results in the five grades shown below based on the number of micro defects detected in the silicon wafer surfaces of 300 mm diameter.
A++: micro defects detected <100
A+: micro defects detected ≥ 100, < 150
A: micro defects detected ≥ 150, < 200
B: micro defects detected ≥ 200, < 500
C: micro defects detected ≥ 500

### < Haze Measurement >

The surface of the respective washed silicon wafers were measured for haze (ppm) in DWO mode, using a wafer inspection system under trade name "SURFSCAN SP2" available from KLA-Tencor Corporation. The measurement results are shown in the three grades indicated below in Table 1 and Table 2.
A: <0.10ppm
B: ≥ 0.10 ppm, < 0.12 ppm
C: ≥ 0.12 ppm

### [Table 1]

**Table 1**

| | | | Example | | | | | Comparative Example | | | | |
|---|---|---|---|---|---|---|---|---|---|---|---|---|
| | | | 1 | 2 | 3 | 4 | 5 | 1 | 2 | 3 | 4 | 5 |
| Composition (wt%) | Abrasive | | 0.2 | 0.2 | 0.2 | 0.2 | 0.2 | 0.5 | 0.5 | 0.2 | 0.2 | 0.5 |
| | Water-soluble polymer | HEC-A (Mw 25×10⁴) | 0.010 | 0.010 | 0.005 | 0.015 | - | 0.020 | 0.020 | - | - | - |
| | | HEC-B (Mw 100×10⁴) | - | - | - | - | - | - | - | 0.010 | 0.010 | 0.010 |
| | | PVA -1 (Mw 13×10⁴, deg. of saponification ≥ 95 mol%) | - | - | - | - | 0.010 | - | - | - | - | - |
| | Surfactant | | - | 0.001 | 0.001 | 0.001 | 0.001 | - | 0.002 | 0.001 | 0.001 | 0.002 |
| | Basic compound (NH₃) | | 0.005 | 0.005 | 0.005 | 0.005 | 0.005 | 0.010 | 0.010 | 0.005 | 0.005 | 0.010 |
| Abrasive | Average primary particle diameter D_{P1} (nm) | | 23 | 24 | 24 | 24 | 24 | 35 | 35 | 12 | 23 | 35 |
| | Average secondary particle diameter D_{P2} (nm) | | 45 | 46 | 46 | 46 | 46 | 66 | 66 | 28 | 45 | 66 |
| Grains in composition | Volume average particle diameter D_{A} (nm) | | 56 | 57 | 57 | 58 | 46 | 80 | 72 | 65 | 71 | 90 |
| | D_{A}/D_{P2} | | 1.24 | 1.24 | 1.24 | 1.26 | 1.00 | 1.21 | 1.09 | 2.32 | 1.58 | 1.36 |
| | D_{A}/D_{P1} | | 2.43 | 2.38 | 2.38 | 2.42 | 1.92 | 2.29 | 2.06 | 5.42 | 3.09 | 2.57 |
| Test Results | Micro defects | | A | A+ | A+ | A+ | A | B | B | C | C | C |
| | Haze | | B | A | A | A | B | C | C | B | B | B |

### [Table 2]

**Table 2**

| | | | Example | | | | | |
|---|---|---|---|---|---|---|---|---|
| | | | 6 | 7 | 8 | 9 | 10 | 11 |
| Composition (wt%) | Abrasive | | 0.2 | 0.2 | 0.2 | 0.2 | 0.1 | 0.1 |
| | Water-soluble polymer | HEC-A (Mw 25×10⁴) | - | - | - | - | 0.005 | 0.005 |
| | | PVA-2 (Mw 1.3×10⁴, deg. of saponification 80 mol%) | - | 0.003 | - | - | - | - |
| | | PVA-3 (Mw 0.5×10⁴, deg. of saponification 80 mol%) | - | - | 0.003 | 0.005 | - | - |
| | | PACMO-1 (Mw 7×10⁴) | 0.005 | - | - | - | - | - |
| | | PACMO-2 (Mw 8×10⁴) | - | - | - | - | 0.003 | - |
| | | PVP (Mw6×10⁴) | - | - | - | 0.003 | - | 0.003 |
| | Surfactant | | 0.001 | 0.001 | 0.001 | 0.001 | 0.0001 | 0.0001 |
| | Basic compound (NH₃) | | 0.005 | 0.005 | 0.005 | 0.005 | 0.005 | 0.005 |
| Abrasive | Average primary particle diameter D_{P1} (nm) | | 24 | 24 | 24 | 24 | 25 | 25 |
| | Average secondary particle diameter D_{P2} (nm) | | 46 | 46 | 46 | 46 | 48 | 48 |
| Grains in composition | Volume average particle diameter D_{A} (nm) | | 48 | 46 | 46 | 46 | 51 | 50 |
| | D_{A/}D_{P2} | | 1.04 | 1.00 | 1.00 | 1.00 | 1.06 | 1.04 |
| | D_{A}/D_{P1} | | 200 | 1.92 | 1.92 | 1.92 | 2.04 | 2.00 |
| Test Results | Micro defects | | A | A+ | A+ | A++ | A++ | A++ |
| | Haze | | B | A | A | A | A | A |

As evident from Table 1, the use of the polishing liquids of Examples 1 to 5 of which the grains in the polishing compositions had D_{A} values in a range of 20 nm to 60 nm (more specifically 35 nm to 60 nm) produced an effect to singificantly reduce the number of micro defects detected when compared with Comparative Examples 1 to 5 using polishing liquids with larger D_{A} values. In comparison of Examples 1 and 2, the use of the surfactant (PEO-PPO-PEO block copolymer with Mw of 9000 herein) produced an effect to reduce the haze while keeping the great effect to reduce micro defects. According to Examples 2 to 4, both micro defect reduction and haze reduction were achieved at a particularly high level.

Also in Examples 6 to 11 shown in Table 2, the polishing liquids of which the grains in the polishing compositions had D_{A} values in the range of 20 nm to 60 nm (more specifically 35 nm to 60 nm) were found to produce an effect to significantly reduce the number of detectable micro defects.

On the contrary, in Comparative Examples 3 to 5 using polishing liquids with D_{A} values above 60 nm, while their haze levels were comparable to Examples 1 and 5, they clearly had more micro defects detected as compared with Examples 1 to 5. With respect to Comparative Examples 1 and 2, while they had fewer micro defects than Comparative Examples 3 to 5, they had higher haze than Examples 1 to 5 and did not achieve both micro defect reduction and haze reduction at a high level. It is noted that in Comparative Examples 2 and 3, despite that their abrasive's average secondary particle diameters were about the same as or smaller than those of Examples 1 to 5, their grains in the polishing compositions had excessively large sizes (D_{A}) and the cause for this may be the large Mw of the water-soluble polymers used in Comparative Examples 2 and 3.

## Claims

1. A polishing composition comprising an abrasive, a water-soluble polymer, and water, wherein
the polishing composition has a volume average particle diameter D_{A} of grains in the polishing composition of 20 nm to 60 nm measured by dynamic light scattering at a concentration equivalent to 0.2 % abrasive content by mass,
the abrasive contains a silica grain and has an average secondary particle diameter D_{P2} of 20 nm to 60 nm, and
the polishing composition has a pH of 9.0 to 11.0.

2. The polishing composition according to Claim 1, wherein the abrasive has an average primary particle diameter D_{P1} of 15 nm to 30 nm.

3. The polishing composition according to Claim 1 or 2, wherein the abrasive has an average secondary particle diameter D_{P2} of 20 nm to 50 nm.

4. The polishing composition according to any one of Claims 1 to 3, wherein the water-soluble polymer has a weight average molecular weight of 1 × 10⁴ to 80 × 10⁴.

5. The polishing composition according to any one of Claims 1 to 4, further comprising a basic compound.

6. A method for producing a polishing composition comprising an abrasive, a water-soluble polymer, a basic compound and water, the method comprising:
obtaining a dispersion comprising the abrasive, basic composition and water;
obtaining an aqueous solution comprising the water-soluble polymer and water; and
adding and mixing the aqueous solution to the dispersion; wherein
the polishing composition comprises grains having a volume average particle diameter D_{A} of 20 nm to 60 nm when measured by dynamic light scattering at a concentration equivalent to 0.2 % abrasive content by mass,
the abrasive contains a silica grain and has an average secondary particle diameter D_{P2} of 20 nm to 60 nm, and
the polishing composition has a pH of 9.0 to 11.0.

7. A method for producing a polished article, the method comprising:
supplying a polishing liquid to a polishing object; and
polishing a surface of the polishing object with the polishing liquid; wherein
the polishing liquid supplied to the polishing object comprises an abrasive, a water-soluble polymer and water, and has a volume average particle diameter D_{A} of grains in the polishing liquid of 20 nm to 60 nm measured by dynamic light scattering,
the abrasive contains a silica grain and has an average secondary particle diameter D_{P2} of 20 nm to 60 nm, and
the polishing liquid has a pH of 9.0 to 11.0.

## Patentansprüche

1. Polierzusammensetzung, umfassend ein Schleifmittel, ein wasserlösliches Polymer und Wasser, wobei
die Polierzusammensetzung einen volumenmittleren Partikeldurchmesser D_{A} von Körnern in der Polierzusammensetzung von 20 nm bis 60 nm aufweist, gemessen durch dynamische Lichtstreuung bei einer Konzentration, die 0,2 Masse-% Schleifmittelgehalt entspricht,
das Schleifmittel ein Siliciumdioxidkorn enthält und einen mittleren Sekundärpartikeldurchmesser D_{P2} von 20 nm bis 60 nm aufweist, und
die Polierzusammensetzung einen pH-Wert von 9,0 bis 11,0 hat.

2. Die Polierzusammensetzung nach Anspruch 1, wobei das Schleifmittel einen mittleren Primärpartikeldurchmesser D_{P1} von 15 nm bis 30 nm aufweist.

3. Die Polierzusammensetzung nach Anspruch 1 oder 2, wobei das Schleifmittel einen mittleren Sekundärpartikeldurchmesser D_{P2} von 20 nm bis 50 nm aufweist.

4. Die Polierzusammensetzung nach einem der Ansprüche 1 bis 3, wobei das wasserlösliche Polymer ein gewichtsmittleres Molekulargewicht von 1 × 10⁴ bis 80 × 10⁴ aufweist.

5. Die Polierzusammensetzung nach einem der Ansprüche 1 bis 4, umfassend ferner eine basische Verbindung.

6. Verfahren zur Herstellung einer Polierzusammensetzung, die ein Schleifmittel, ein wasserlösliches Polymer, eine basische Verbindung und Wasser umfasst, wobei das Verfahren umfasst:
Erhalten einer Dispersion, die das Schleifmittel, eine basische Zusammensetzung und Wasser umfasst;
Erhalten einer wässrigen Lösung, die das wasserlösliche Polymer und Wasser umfasst; und
Hinzufügen und Mischen der wässrigen Lösung zu der Dispersion; wobei
die Polierzusammensetzung Körner mit einem volumenmittleren Partikeldurchmesser D_{A} von 20 nm bis 60 nm, gemessen durch dynamische Lichtstreuung bei einer Konzentration, die 0,2 Masse-% Schleifmittelgehalt entspricht, umfasst,
das Schleifmittel ein Siliciumdioxidkorn enthält und einen mittleren Sekundärpartikeldurchmesser D_{P2} von 20 nm bis 60 nm aufweist, und
die Polierzusammensetzung einen pH-Wert von 9,0 bis 11,0 hat.

7. Verfahren zur Herstellung eines polierten Gegenstandes, wobei das Verfahren umfasst:
das Zuführen einer Polierflüssigkeit zu einem Polierobjekt; und
Polieren einer Oberfläche des Polierobjekts mit der Polierflüssigkeit; wobei
die dem Polierobjekt zugeführte Polierflüssigkeit ein Schleifmittel, ein wasserlösliches Polymer und Wasser umfasst und einen volumenmittleren Partikeldurchmesser D_{A} von Körnern in der Polierflüssigkeit von 20 nm bis 60 nm, gemessen durch dynamische Lichtstreuung, aufweist,
das Schleifmittel ein Siliciumdioxidkorn enthält und einen mittleren Sekundärpartikeldurchmesser D_{P2} von 20 nm bis 60 nm aufweist, und
die Polierflüssigkeit einen pH-Wert von 9,0 bis 11,0 hat.

## Revendications

1. Composition de polissage comprenant un abrasif, un polymère hydrosoluble et de l'eau,
la composition de polissage ayant un diamètre de particule moyen en volume D_{A} des grains dans la composition de polissage de 20 nm à 60 nm mesuré par diffusion dynamique de la lumière à une concentration équivalent à 0,2 % de teneur massique d'abrasif,
l'abrasif contenant un grain de silice et ayant un diamètre de particule secondaire moyen D_{P2} de 20 nm à 60 nm, et
la composition de polissage ayant un pH de 9,0 à 11,0.

2. Composition de polissage selon la revendication 1, l'abrasif ayant un diamètre de particule primaire moyen D_{P1} de 15 nm à 30 nm.

3. Composition de polissage selon la revendication 1 ou 2, l'abrasif ayant un diamètre de particule secondaire moyen D_{P2} de 20 nm à 50 nm.

4. Composition de polissage selon l'une quelconque des revendications 1 à 3, le polymère hydrosoluble ayant une masse moléculaire moyenne en poids de 1 × 10⁴ à 80 × 10⁴.

5. Composition de polissage selon l'une quelconque des revendications 1 à 4, comprenant en outre un composé basique.

6. Procédé de production d'une composition de polissage comprenant un abrasif, un polymère hydrosoluble, un composé basique et de l'eau, le procédé comprenant :
l'obtention d'une dispersion comprenant l'abrasif, la composition basique et de l'eau ;
l'obtention d'une solution aqueuse comprenant le polymère hydrosoluble et de l'eau ;
et l'ajout et le mélange de la solution aqueuse à la dispersion ;
la composition de polissage comprenant des grains ayant un diamètre de particule moyen en volume D_{A} de 20 nm à 60 nm quand il est mesuré par diffusion dynamique de lumière à une concentration équivalent à 0,2 % de teneur massique d'abrasif,
l'abrasif contenant un grain de silice et ayant un diamètre de particule secondaire moyen D_{P2} de 20 nm à 60 nm, et
la composition de polissage ayant un pH de 9,0 à 11,0.

7. Procédé de production d'un article poli, le procédé comprenant :
l'apport d'un liquide de polissage à un objet de polissage ; et
le polissage d'une surface de l'objet de polissage avec le liquide de polissage ;
le liquide de polissage apporté à l'objet de polissage comprenant un abrasif, un polymère hydrosoluble, un composé basique et de l'eau, et ayant un diamètre de particule moyen en volume D_{A} des grains dans le liquide de polissage de 20 nm à 60 nm mesuré par diffusion dynamique de lumière,
l'abrasif contenant un grain de silice et ayant un diamètre de particule secondaire moyen D_{P2} de 20 nm à 60 nm, et
le liquide de polissage ayant un pH de 9,0 à 11,0.
